# EUROPÄISCHE PATENTSCHRIFT

(11) **EP 4 350 938 B1**
(45) Veröffentlichungstag und Bekanntmachung des Hinweises auf die Patenterteilung: **28.10.2026**
(21) Anmeldenummer: 24155407.0
(22) Anmeldetag: 20.07.2022
(51) Int. Cl.: G01R 31/392, H01M 10/48, H02J 7/00, H01M 10/44, H01M 10/42

(54) **VERFAHREN ZUR BESTIMMUNG DER LEISTUNGSFÄHIGKEIT VON ELEKTRISCHEN ENERGIESPEICHERN**
METHOD FOR DETERMINING THE PERFORMANCE OF ELECTRICAL ENERGY STORAGE SYSTEMS
MÉTHODE DE DÉTERMINATION DE LA PERFORMANCE DES ACCUMULATEURS D'ÉNERGIE ÉLECTRIQUE

(30) Priorität: 20.07.2021 DE 102021118781
(43) Veröffentlichungstag der Anmeldung: 10.04.2024
(62) Dokumentnummer(n) der früheren Anmeldung(en) nach Art. 76 EPÜ: 22744221.7 / 4 217 754
(73) Patentinhaber: volytica diagnostics GmbH, 01097 Dresden (DE)
(72) Erfinder: Jehle, Claudius, 80469 München (DE); Stoll, Sebastian, 01157 Dresden (DE); Morawietz, Lutz, 01277 Dresden (DE)
(74) Vertreter: Rössler, Thomas

(56) Entgegenhaltungen:
- EP-B1- 2 065 718
- WO-A1-2020/045059
- WO-A1-2020/246932

## Beschreibung

### Technisches Gebiet

Die vorliegende Erfindung betrifft den Bereich der elektrischen Energiespeicher, insbesondere ein Verfahren zur Bestimmung der Leistungsfähigkeit eines elektrischen Energiespeichers, insbesondere für Elektrofahrzeuge.

### Stand der Technik

Im Bereich des Elektrofahrzeugs stellt die Leistungsfähigkeit, teilweise als SoH (State of Health, Gesundheitszustand) bezeichnet, einen wichtigen Parameter bzw. ein wichtiges Set von Parametern der Fahrzeugbatterie dar und wird als Indikator des Batterie-Gesundheitszustands verwendet. Oft wird als State of Health (SoH oder SOH) eine Kenngröße für Akkumulatoren bezeichnet, die dessen Leistungsfähigkeit im Kontext dessen Alterung beschreibt. Der Fachmann versteht hierunter mindestens eine Größe, die eine Aussage über die Fähigkeit des Speichers beschreibt, seine designierte Anforderung zu erfüllen. Oft wird sein Vermögen, eine bestimmte Menge Energie oder Ladung zu speichern und abzugeben, verstanden (auch Kapazität oder maximale Kapazität). Oft wird auch sein Vermögen verstanden, mit welcher Geschwindigkeit diese abgegeben oder aufgenommen werden kann (Leistung, Power), was im Zusammenhang mit seiner Impedanz, oft auch vereinfachend als Widerstand bezeichnet, steht. Im Mittelpunkt steht dabei, in welchem Zustand sich der Energiespeicher befindet. Wie alle anderen Geräte, die mit einem wiederaufladbaren Energiespeicher ausgestattet sind, verringert sich auch bei E-Autos die Leistungsfähigkeit dieses Energiespeichers. Viele Hersteller sprechen für ihre E-Autos SoH-Garantien aus, welche die Kapazitätsverluste des Akkus einschließt. Im Stand der Technik wird der Gesundheitszustand der Batterie durch ein innerhalb des Fahrzeugs angeordnetes Batteriemanagementsystem (BMS) anhand einer großen Menge an Werkprüfungsdaten der Batterie über eine Online-Prüfung erfasst.

Bei elektrischen Fahrzeugen macht einen wesentlichen Teil des monetären Wertes der elektrische Energiespeicher aus. Bei der Alterung eines Energiespeichers steigt oft der Widerstand bzw. die Impedanz verändert sich, wodurch sich die Leistungsfähigkeit verschlechtert. Auch sinkt die Kapazität und damit die Reichweite. In einem beispielhaften Szenario eines Gebrauchtwagen-Verkaufes ist es daher von Interesse, die Leistungsfähigkeit des elektrischen Energiespeichers möglichst genau zu beurteilen. Der Kunde/ Fahrzeughalter ist insbesondere an der verbleibenden Restreichweite, die mit einer Batterie bzw. dem Energiespeicher zu erreichen ist, interessiert, die ein wichtiger Aspekt der Leistungsfähigkeit sein kann.

Die Patentschrift EP 2 306 214 A1 offenbart eine Methode, wobei die DC Impedanz gemessen wird und wobei diese Impedanz mit einem Referenz-Widerstand verglichen wird. Dabei wird der Widerstand sowohl beim Laden als auch Entladen der Batterie gemessen. Für das Messverfahren wird bei Ladung der Batterie die Batterie auf 35°C aufgewärmt oder gekühlt, um optimale Ladebedingungen und geringe Verzögerung des Ladeprozesses durch die Messung zu erhalten. Dieses System nutzt einen eigenen Kommunikations-Bus zwischen dem Ladegerät, dem Batteriemanagementsystem und dem Beurteilungssystem. Das Messverfahren setzt somit allerdings voraus, dass Messwerte aus dem Fahrzeug, insbesondere aus der CPU bzw. des BMS des Fahrzeugs hinzugezogen werden müssen, was ohne Vorliegen einer bekannten, geeigneten, offengelegten Schnittstelle für einen unabhängigen Dritten nicht allgemein möglich ist. Das Verfahren ist somit nur für den Fahrzeughersteller oder seine Auftragnehmer, nicht aber für Unabhängige, möglich.

DE 10 2017 125 274 B3 offenbart ein Verfahren zur Erfassung des Gesundheitszustands einer Batterie. Hierzu wird ein System bestehend aus einem Fahrzeug, dessen Energiespeicher, einer Ladeeinrichtung und einem Cloud-Server verwendet. Dieses System erfasst die Batteriedaten wie Temperatur, Strom, Spannung, SOC (State Of Charge), Hersteller, Typ, vergangene Fehlercodes und vergangene Ausnahmecodes während sich die Batterie im Zustand der Aufladung befindet, und übermittelt die erfassten Aufladungsdaten an den Cloud-Server. Dabei ermittelt der Cloud-Server erst nach Aufladungsabschluss der Batterie in Abhängigkeit sämtlicher gespeicherter Aufladungsdaten anhand eines algorithmischen Modells den Gesundheitszustand der Batterie. Dieses algorithmische Modell kann zwar lernfähig ausgestaltet sein und nach jedem Ladevorgang aktualisiert werden, allerdings ist dieses Verfahren sehr zeitaufwändig, da der Gesundheitszustand des Energiespeichers erst nach Aufladungsabschluss, d.h. nachdem der Speicher komplett befüllt wurde (was mehrere Stunden in Anspruch nehmen kann), sowie nur in Abhängigkeit sämtlicher gespeicherter Aufladungsdaten ermittelt werden kann.

WO2020045059A1 offenbart eine Diagnosevorrichtung, die umfasst: einen Erfassungsteil, der erste Ladeinformationen, die einen ersten erfassten Wert enthalten, der von einem externen Ladegerät erfasst wird, während eine in einem Fahrzeug eingebaute Batterie geladen wird, und zweite Ladeinformationen, die einen zweiten erfassten Wert enthalten, der von dem Fahrzeug erfasst wird, erfasst; und einen Verschlechterungsabschätzungsteil, der auf der Grundlage der ersten Ladeinformationen und der zweiten Ladeinformationen einen Verschlechterungsgrad abschätzt, der die Verschlechterung der Batterie anzeigt. Das Verfahren und die offenbarte Vorrichtung sind jedoch limitiert in ihrer Genauigkeit, wodurch nur eine unzureichend genaue Abschätzung bereitgestellt wird.

Das Patent EP 2 065 718 B1 bestimmt die Verschlechterung der Batterie als die Veränderung der Ladeeffizienz. Durch die Messung der von der Ladestation an das Fahrzeug gelieferten Strommenge und der tatsächlich im Energiespeicher des Fahrzeuges gespeicherten Energie wird die Ladeeffizienz berechnet. Die berechnete Ladeeffizienz wird lokal in einem Verschlechterungs-Beurteilungssystem gespeichert, welches Teil der Ladestation ist. Das Kabel zur Leistungsübertragung wird gleichzeitig für die Kommunikation zwischen Fahrzeug-Energiespeicher und Bewertungssystem genutzt. Nachteilig ist auch hier, dass die Ladeeffizienz des Energiespeichers nur dann berechnet werden kann, wenn die tatsächlich im Energiespeicher des Fahrzeuges gespeicherte Energiemenge bekannt ist, sodass auch hier zwingend Messwerte aus Steuereinheiten oder CPUs des Fahrzeugs hinzugezogen werden müssen. Das Verfahren ist somit nur für den Fahrzeughersteller oder seine Auftragnehmer, nicht für Unabhängige, möglich.

Das Patent WO 2011 135813 A1 offenbart ein Zustandsmanagementsystem für einen Energiespeicher, welches ein Ladegerät umfasst, das die elektrischen Eigenschaften während des Ladens eines Energiespeichers erfasst und diese mit den in einem Datenspeicher gespeicherten Kenngrößen für denselben Energiespeicher vergleicht und daraus den Zustand dieses Energiespeichers bestimmt. Die erfassten Messdaten sind Ladestrom, Ladespannung und Umgebungstemperatur des Ladegerätes und werden mit historischen Daten, die in einer Messinformationsspeichereinheit dieses Energiespeichers gespeichert sind, verglichen. Aus dem Vergleich wird die Verschlechterung der Batterie bestimmt. Die Batterie kommuniziert mit dem Ladegerät und dem Server. Auf dem Server werden die vergangenen Ladedaten gespeichert. Der Server beinhaltet ebenfalls einen Analytik-Baustein, welcher die Verschlechterung des Akkus bestimmt.

Auch dieses Verfahren ist somit nur für den Fahrzeughersteller oder seine Auftragnehmer, nicht für Unabhängige, möglich.

Im Ergebnis ist die Möglichkeit zur unabhängigen Beurteilung der Leistungsfähigkeit elektrischer Energiespeicher für unabhängige Dritte bisher nicht gegeben. In der Lage dazu sind lediglich Fahrzeug- und Batteriehersteller mit Zugriffsrechten auf die interne Steuereinheiten, bspw. CPUs, welche mit dem BMS kommuniziert. Ein unabhängiger Dritter wäre bspw. der Fahrzeugbesitzer, ein Gebrauchtwagenhändler oder eine Fahrzeugwerkstatt. Gibt es für unabhängige Dritte eine Möglichkeit, so ist diese immer für ein Fahrzeug bzw. einen spezifischen Fahrzeugtyp oder einen Energiespeicher angepasst, und diese Möglichkeit lässt sich nicht auf andere Gegebenheiten übertragen. Ein Vergleich der Leistungsfähigkeit verschiedener elektrischer Energiespeicher ist nicht möglich. Die genannten Lösungsansätze setzen nachteilig vielmehr eine problemlose, sowohl technische als auch rechtliche, Verfügung der zu messenden Signale innerhalb eines Fahrzeugs oder eines elektrischen Energiespeichers voraus.

Da es unabhängigen Dritten bisher insbesondere von den Herstellern der Fahrzeuge verwehrt ist auf interne Fahrzeugsysteme wie die CPU zuzugreifen, sind die dort prozessierten Daten, insbesondere die Daten des BMS, nicht, oder nur eingeschränkt durch unabhängige Dritten abrufbar.

Weiterhin konzentrieren sich die derzeit bekannten Verfahren zur Bestimmung der Leistungsfähigkeit einer Batterie auf die zeitaufwendige Ermittlung des Ladungsinhaltes (komplette Voll- / Entladung) innerhalb eines Zeitraums.

Der Stand der Technik bietet somit aktuell keine Möglichkeit eine schnelle und unabhängige Bestimmung der Leistungsfähigkeit einer Batterie durch einen unabhängigen Dritten vorzunehmen, ohne auf die internen Fahrzeugsysteme zugreifen zu müssen.

Keiner der aus dem Stand der Technik bekannten Lösungsansätze berücksichtigt die Stillstandzeit der Fahrzeuge, wobei die Energiespeicher quasi keiner Nutzung unterlagen. Ferner berücksichtigt keiner der in den genannten Patentschriften beschriebenen Lösungsansätze die Umgebungsdaten (z.B. Temperatur, Luftfeuchte) des Energiespeichers. Dabei haben die Erfinder dieses Lösungsansatzes herausgefunden, dass aber eben auch diese Daten von Interesse sind, da diese Rückschlüsse auf den Zustand, ganz speziell auf das thermische, elektrochemische, chemische und thermodynamische Gleichgewicht, des Energiespeichers erlauben, die zur genaueren und/oder schnelleren Bestimmung der Leistungsfähigkeit bzw. Werten, die mit dieser zusammenhängen, hilfreich sind (bspw. zur Kompensation parasitärer Effekte).

### Aufgabe

Es ist daher Aufgabe der vorliegenden Erfindung ein Verfahren bereitzustellen, mit welchem die Leistungsfähigkeit eines elektrischen Fahrzeug-Energiespeichers in einem kurzen Zeitraum verlässlich und präzise beurteilt werden kann, ohne auf Detailinformationen aus dem Fahrzeug angewiesen zu sein, die einem unabhängigen Dritten nicht zugänglich sind.

Dabei ist insbesondere Aufgabe, dass das Verfahren flexibel einsetzbar ist, für verschiedenste Fahrzeugtypen und für unabhängige Dritte zugänglich, ohne dass Einbußen in Genauigkeit, Verlässlichkeit und Präzision der gewonnenen Leistungsfähigkeitsbestimmung hingenommen werden müssen.

### Lösung

Durch die vorliegende Erfindung wird ein Verfahren bereitgestellt, das eine Ermittlung der Leistungsfähigkeit elektrischer Energiespeicher von außerhalb eines Fahrzeugs ohne den Zugriff auf dessen interne Kommunikations- und Elektronik-Systeme ermöglicht.

Die vorliegenden Aufgaben kann durch ein Verfahren zur Bestimmung der Leistungsfähigkeit von elektrischen Energiespeichern gemäss dem Anspruch 1 gelöst werden.

Ein Verfahren zur Bestimmung der Leistungsfähigkeit von elektrischen Fahrzeug-Energiespeichern kann die folgenden Schritte umfassen:
a) Bereitstellen eines Fahrzeug-Energiespeichers an einem Zwischenkreis,
b) Bereitstellen einer vom Fahrzeug-Energiespeicher oder dem Zwischenkreis lösbaren Ladeeinrichtung,
c) Bereitstellen von mindestens zwei stromführenden Leistungskanälen vorzugsweise direkt von der Ladeeinrichtung zu dem Fahrzeug-Energiespeicher oder dem Zwischenkreis,
d) Ermitteln mindestens eines Stroms, insbesondere mindestens einer Stromstärke, des Fahrzeug-Energiespeichers,
e) Ermitteln mindestens einer Spannung des Fahrzeug-Energiespeichers,
f) Ermitteln mindestens eines Widerstandes des Fahrzeug-Energiespeichers,
   und
g) Ermitteln von weiteren physikalischen Größen als Messwerte,

wobei ein zeitlich veränderbarer Stromanstieg oder Stromabfall zur Bestimmung der Leistungsfähigkeit, insbesondere des Widerstandes, des Fahrzeug-Energiespeichers herangezogen wird,
wobei die Bestimmung von Strom und Spannung außerhalb des Fahrzeugs, vorzugsweise innerhalb der Ladeeinrichtung, erfolgt,
wobei zur Bestimmung der Leistungsfähigkeit des Energiespeichers Einflüsse anderer Komponenten, insbesondere parasitäre Effekte, als des Energiespeichers am Zwischenkreis und/oder Komponenten zwischen der Ladeeinrichtung und dem Energiespeicher herausgerechnet werden,
wobei zur Herausrechnung jener Einflüsse mindestens eine externe physikalische Größe, sowie bereits bekannte Informationen über den Energiespeicher oder bereits bekannte Informationen über mit dem Energiespeicher vergleichbare Energiespeicher hinzugezogen werden.

Die von außen unabhängig zugänglichen Informationen werden dabei fachmännisch so weiterverarbeitet, dass etwaige mitgemessene oder mitbestimmte Effekte, die nicht auf die Leistungsfähigkeit des Speichers zurückzuführen sind - so beispielsweise Effekte aus dem Zwischenkreis und/oder Umgebungsbedingungen (allgemein "parasitäre Effekte"), isoliert und rechnerisch größtenteils entfernt werden. Durch dieses Vorgehen wird eine flexible und gleichzeitig besonders präzise Bestimmung der Leistungsfähigkeit geschaffen. Insbesondere sind die Leistungsfähigkeitsbestimmungen gut vergleichbar und von parasitären Effekten, insbesondere im jeweiligen Fahrzeug, befreit. Letzteres bringt eine erhöhte Präzision (precision) als auch Genauigkeit/Akkuratheit (accuracy) in Bezug auf die technisch wirklich interessante(n) physikalische(n) Größe(n) mit sich.

Das Verbinden der Ladeeinrichtung mit dem Fahrzeug-Energiespeicher erfolgt hierbei vorzugsweise über mindestens zwei stromführende Leistungskanäle von der Ladeeinrichtung zu dem Fahrzeug-Energiespeicher oder dem Zwischenkreis innerhalb des Fahrzeugs, an welchem sich der Energiespeicher befindet, sodass diese vorzugsweise direkt miteinander verbunden werden. Der Begriff "direkt" bedeutet hierin, dass die Ladeeinrichtung unmittelbar galvanisch leitend mit dem Fahrzeug-Energiespeicher und/oder dem Zwischenkreis gekoppelt ist, d.h. nicht über aktive Leistungselektronik wie einem Wechselrichter ("DC-Kopplung").

Vorzugsweise erfolgt das temporäre Ermitteln der Aufladungsdaten des Fahrzeug-Energiespeichers und/oder des Zwischenkreises durch die Ladeeinrichtung innerhalb eines Zeitintervalls Δt_{E} während des Zeitraums des Auf- und/oder Entladevorgangs Δt_{A}, wobei Δt_{E} < Δt_{A}. Dies hat den Vorteil, dass das Verfahren zur Bestimmung der Leistungsfähigkeit des Energiespeichers wesentlich schneller erfolgen kann, da im Gegensatz zum Stand der Technik nicht abgewartet werden muss, bis der Energiespeicher vollends aufgeladen ist, d.h. sich der Energiespeicher (hierin bspw. die Batterie oder der Akku) im Zustand der Aufladung befindet, weil bspw. sämtliche Aufladungsdaten des betreffenden Fahrzeugs bzw. des Energiespeichers ermittelt werden müssen. Dies wird erfindungsgemäß dadurch realisiert, dass innerhalb des Verfahrens ein zeitlich veränderbarer Stromanstieg oder Stromabfall zur Bestimmung der Leistungsfähigkeit, insbesondere des Widerstandes des Fahrzeug-Energiespeichers herangezogen wird, und bereits bekannte Informationen über den Energiespeicher oder bereits bekannte Informationen über mit dem Energiespeicher vergleichbare Energiespeicher hinzugezogen werden.

Zur Lösung der Aufgabe wird eine Ladeeinrichtung für elektrische Fahrzeug-Energiespeicher benötigt. Darin kann das Verfahren umgesetzt werden. Die Leistungsfähigkeit steht im Zusammenhang mit dem Widerstand und/oder der Energieaufnahmefähigkeit des elektrischen Energiespeichers. Der Widerstand wird über einen veränderlichen Lade- oder Entladestrom ermittelt, wobei der veränderliche Strom einen definierten Anstieg oder Abfall in einem definierten Zeitraum aufweist und eine vorgegebene Stromstärke erreicht. Es ist hierbei unerheblich, ob es sich um eine Be- oder Entladung handelt.

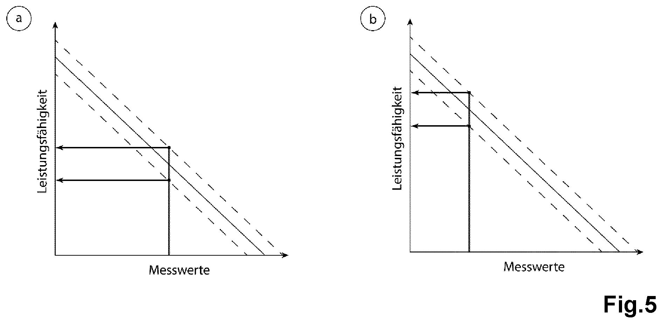

Insbesondere kann ein Widerstand oder eine Impedanz, insbesondere ein Widerstand oder eine Impedanz des Energiespeichers, auch über Messwerte, die sich unmittelbar während und nach einer starken Reduktion des Stroms (Abschaltung) ergeben, ermittelt werden. Die Energieaufnahmefähigkeit wird entweder über den gemessenen Widerstand über bekannte oder zu ermittelnde Zusammenhänge (siehe Fig. 5), bspw. über Statistik oder vorherige Ausmessung, oder über die Bestimmung durch Messdauer, Ladestrom und vorteilhafterweise Informationen über die Spannung berechnet. Der Wirkungsgrad wird dabei als Verhältnis der vom elektrischen Energiespeicher aufgenommenen und abgegebenen Ladungsmenge, berechnet. Parasitäre Einflüsse werden bei der Ermittlung des Widerstandes berücksichtigt. Die Leistungsfähigkeit wird vor Ort oder teilweise vor Ort ermittelt.

Lässt eine Ladeeinrichtung nicht die Implementierung dieses hierin offenbarten Verfahrens zu, kann ein Adapter zwischen die Ladeeinrichtung und den elektrischen Energiespeicher geschaltet werden, welcher das Verfahren umsetzt.

Weitere vorteilhafte Ausgestaltungen sind den Unteransprüchen und der Beschreibung zu entnehmen.

### Allgemeine Vorteile

Das vorliegende Verfahren ermöglicht die objektive Vergleichbarkeit verschiedener elektrischer Energiespeicher. Dabei werden alle notwendigen Daten außerhalb des den Energiespeicher umfassenden Fahrzeugs erfasst.

Die teilweise oder komplett lokal erfolgende Berechnung der Leistungsfähigkeit ermöglicht dem Nutzer eine schnelle Verfügbarkeit der Ergebnisse, ohne dass eine zeitaufwendige Bestimmung des Ladungsinhaltes erforderlich ist oder dass eine zeit- und ressourcenaufwendige Überführung einzelner oder aller Daten in eine Cloud erforderlich ist.

Darüber hinaus kann dadurch, dass innerhalb des Verfahrens im Gegensatz zu herkömmlichen Verfahren ein zeitlich veränderbarer Stromanstieg oder Stromabfall zur Bestimmung der Leistungsfähigkeit, insbesondere des Widerstandes des Fahrzeug-Energiespeichers herangezogen wird, auf das zeitaufwendige (Voll-)laden und/oder (Ent- )laden, insbesondere vollständige (d.h. Ladehübe >90%) oder fast vollständige (d.h. Ladehübe >50%), des Energiespeichers verzichtet werden.

Durch das vorliegende Verfahren ist die Nutzung bereits existierender Ladeinfrastruktur möglich. Dadurch können Ressourcen geschont werden, welche andernfalls bei einer Erneuerung der Ladeinfrastruktur angefallen wären.

Dadurch, dass die Ladeeinrichtung unmittelbar mit dem Fahrzeug-Energiespeicher und/oder dem Zwischenkreis gekoppelt ist, sodass ausschließlich oder zumindest primär auf Daten des Fahrzeug-Energiespeichers zugegriffen wird, wird die Batteriediagnostik für unabhängige Dritte, welche nicht Fahrzeug- oder Batteriehersteller sind, ermöglicht, wodurch eine unabhängige Bewertung des Ladezustands eines Fahrzeug-Energiespeichers möglich wird und sich hieraus neue Geschäftsfelder, sowohl für die Forschung als auch für die Privatwirtschaft, eröffnen.

### Beschreibung der Erfindung

Das erfindungsgemäße Verfahren beschreibt die Bestimmung der Leistungsfähigkeit von elektrischen Energiespeichern.

Ein elektrischer Fahrzeug-Energiespeicher umfasst zumindest ein energiespeicherndes Element, welches dazu geeignet ist, eine elektrische Energie aufzunehmen und bei Bedarf wieder abzugeben. Der Energiespeicher kann auch als Sekundärbatterie, Akkumulator oder Batterie bezeichnet werden. Der Vorgang der Aufnahme elektrischer Energie wird als Laden oder Ladung bezeichnet. Diese erfolgt mit einer Stromstärke und einer Spannung. Der Vorgang des Abführens der elektrischen Energie aus dem energiespeichernden Element wird als Entladen oder Entladung bezeichnet. Im Allgemeinen werden solche Elemente als Akkumulatoren oder auch als Sekundärbatterie bezeichnet, welche elektrische Energie auf elektrochemischer Basis speichern. Im Sinne der Erfindung sind mit energiespeichernden Elementen aber auch Batterien (Primärbatterien) umfasst, welche nicht wiederaufgeladen werden können. Im Sinne der Erfindung können energiespeicherndes Element, Akkumulator, Batterie synonym verwendet werden. Im Sinne der Erfindung sind mit Sekundärbatterie Bleiakkumulatoren, Nickel-Metallhydrid Akkumulatoren, Lithium-Ionen-Akkumulatoren sowie Nickel-Cadmium-Akkumulatoren umfasst. Die Akkumulator-Zellen können in Reihe und/oder parallelgeschaltet sein.

Als Fahrzeug sind insbesondere Automobile, Elektroroller, E-Bikes, Hoverboards, Segways, Schiffe, Boote sowie Segelflugzeuge umfasst. Ebenso umfasst sind mit Akkumulatoren bzw. Energiespeichern betriebene Haushaltsgeräte (z.B. Staubsaugroboter) oder Modellbaugeräte (z.B. Drohnen, Flugmodelle). Da zur Bestimmung der Leistungsfähigkeit des elektrischen Fahrzeug-Energiespeichers erfindungsgemäß auf Detailinformationen aus dem Fahrzeug verzichtet werden kann, sondern lediglich ein direkter Zugriff auf den Energiespeicher erforderlich ist, kann das energiespeichernde Element bzw. der Fahrzeug-Energiespeicher dabei vorteilhaft während des Verfahrens zur Bestimmung dessen Leistungsfähigkeit in einem Fahrzeug verbaut sein, oder getrennt von diesem vorliegen.

Vorzugsweise ist der Fahrzeug-Energiespeicher während der Durchführung des Verfahrens zur Bestimmung von dessen Leistungsfähigkeit in ein Fahrzeug integriert. Dies erspart vorteilhaft unnötige Arbeitsschritte, um den Fahrzeug-Energiespeicher aufwändig aus dem Fahrzeug auszubauen.

Weiterhin sind durch den Begriff Energiespeicher stationäre Energiespeicher umfasst, also Einrichtungen, in welchen Akkumulatoren verbaut sind.

Das erfindungsgemäße Verfahren soll insbesondere die Bestimmung der verbleibenden Leistungsfähigkeit des Energiespeichers erlauben. Im Sinne der Erfindung wird unter der Leistungsfähigkeit eines elektrischen Energiespeichers verstanden, dass das energiespeichernde Element in der Lage ist eine dafür vorgesehene Aufgabe zu erfüllen. Dabei umfasst eine solche Aufgabe beispielsweise die Bereitstellung elektrischer Energie um diese entweder in kinetische Energie (z.B. für den Betrieb eines Elektromotors) und/oder in thermische Energie (z.B. für den Betrieb einer Heizung) umzusetzen. Weiterhin kann die elektrische Energie auch nicht in eine andere Energieform umgesetzt werden, beispielsweise wenn eine elektrische Einheit (z.B. Sensorik, Computer) betrieben werden soll. Die Leistungsfähigkeit kann als State of Health (SoH) bezeichnet werden. Erfindungsgemäß kann die Leistungsfähigkeit auch ein Überbegriff für noch zu definierende Größen sein. Diese umfassen beispielsweise den Widerstand, die Kapazität, oder Verrechnungen aus diesen oder weiteren Messwerten und/oder geschätzten Werten. Die Leistungsfähigkeit kann beispielsweise als eine Zahl angegeben werden. Die Leistungsfähigkeit kann beispielsweise nach einem Ampelsystem (z.B. grün, gelb, rot) angegeben werden. Die Leistungsfähigkeit kann beispielsweise als ein Rating (z.B. A, AA, AAA, B, BB, BBB) angegeben werden. Unabhängig davon, wie die Leistungsfähigkeit berechnet wird, soll diese beispielsweise dem Fahrzeughalter einen einfachen Vergleich mit der Leistungsfähigkeit anderer Fahrzeuge ermöglichen.

Die Leistungsfähigkeit des Energiespeichers kann geschätzt werden, indem eine erste Spannung des Energiespeichers und/oder des Zwischenkreises bestimmt wird, eine bestimmte -gemessene- Ladungsmenge, welche nicht ausreicht, den Energiespeicher vollständig zu füllen, in den Energiespeicher und/oder den Zwischenkreis geladen wird, und anschließend eine zweite Spannung bestimmt wird, und anschließend aus dem Vergleich zwischen der Differenz zwischen der ersten und zweiten Spannung mit einer erwarteten Differenz auf die Leistungsfähigkeit geschlossen wird, wobei die erwartete Differenz aus der bestimmten, bekannten Ladungsmenge und vorbekannten Informationen (z.B. in Lookup-Tabellen oder einer Cloud hinterlegt) des Energiespeichers oder mit dem Energiespeicher vergleichbarer Energiespeicher bekannt ist. Eine Aufladung führt zu einer Spannungsänderung. Wenn man die tatsächliche Spannungsänderung mit einer erwartbaren (bspw. aus Cloud-Statistik) vergleicht, kann auf die Ladungsaufnahmefähigkeit geschlossen werden.

Für die Bestimmung der Leistungsfähigkeit umfasst das erfindungsgemäße Verfahren eine Ladeeinrichtung, welche lösbar mit dem Fahrzeug verbunden/verbaut sein kann, oder fest mit dem Fahrzeug verbunden ist. Vorzugsweise ist die Ladeeinrichtung direkt und lösbar mit dem Energiespeicher verbunden.

Unter einer Ladeeinrichtung wird ein Element verstanden, welches eine elektrische Energiemenge an das energiespeichernde Element abgibt oder aufnimmt. Insbesondere befindet sich eine Ladeeinrichtung vorteilhafterweise außerhalb des Fahrzeugs und ist zumindest während eines Lade- oder Entladevorgangs mit einer Energiequelle, beispielsweise einem externen Versorgungsnetz oder einer andere Energiespeichereinheit, deren Energiebereitstellungsvermögen einen signifikanten Ladungshub erlaubt, verbunden. Was ein signifikanter Ladungshub ist, definiert sich in Bezug auf die Gesamtkapazität des Energiespeichers und/oder auf den üblichen Verbrauch eines mit dem Fahrzeug-Energiespeichers betriebenen Fahrzeugs. Eine beispielhafte Ladeeinrichtung kann das energiespeichernde Element problemlos um mindestens 10% aufladen, oder gar mehr, zum Beispiel 50%, bis zu 100%. Beispielsweise geschieht dies in einigen Stunden, oder in weniger als einer Zeitstunde. Ebenso ist mit einer Ladeeinrichtung eine Vorrichtung umfasst, welche zusätzliche Funktionen, beispielsweise zum Erfassen/Ermitteln verschiedener Parameter erlaubt. Hierzu können die Ladeeinrichtung und der Energiespeicher neben einem Ladekabel und/oder mehreren Leistungskanälen zum Versorgen des Energiespeichers mit elektrischer Energie auch über ein Datenübertragungskabel, beispielsweise einen CAN-Bus (Controller Area Network, Steuergerätenetz) miteinander verbunden sein. Reine Diagnostikgeräte sind jedoch keine Ladeeinrichtungen, da die hier fließenden Ströme in der Regel vernachlässigbar klein sind. Vernachlässigbar sind erreichbare Stromstärken insbesondere dann, wenn ein Ladungshub um 10% länger als 1 Zeitstunde dauern würde.

Die Menge der abgegebenen Energie kann beispielsweise von einer informationstechnischen Einheit (z.B. Computer, elektronische Schaltung) gesteuert werden.

Die Ladeeinrichtung umfasst mindestens zwei Leistungskanäle. Unter einem Leistungskanal wird ein Element verstanden, welches von einem elektrischen Pol der Ladeeinrichtung zu einem elektrischen Pol des energiespeichernden Elements führt, wobei die transportierte elektrische Energie durch die Pole transportiert wird. Zwischen den Leistungskanälen kann die Spannung mit einem Voltmeter gemessen werden. Die Messung des Stroms kann beispielsweise mit einem Amperemeter erfolgen, welches in Reihe zum Innenwiderstand des energiespeichernden Elements geschaltet ist. Alternativ kann der Strom über die Messung der Spannung an einem (bekannten) Widerstand ermittelt werden. Ein Leistungskanal umfasst beispielsweise ein Ladekabel oder einen Stecker. Ein Leistungskanal kann außerdem als eine Kommunikationsschnittstelle einen BUS umfassen (Kommunikationsbus/Datenübertragungsbus). Unter einem BUS wird ein System verstanden, das zusätzlich zu, beispielsweise einen Akkumulator ladende, stromführende Elemente, Leiterbahnen umfasst, die der informationstechnischen Kommunikation, also der Übertragung von Daten in elektronischer Form dienen. Beispielsweise stellt ein USB-Kabel einen BUS dar. Erfindungsgemäß umfassen Datenübertragungsstandards einen Profibus, USB, OCPP (open charge point protocol).

Die Messung der Werte von Strom und/oder Spannung kann an der Ladeeinrichtung erfolgen, welche sich innerhalb oder bevorzugt außerhalb des Fahrzeugs befinden kann. Dabei wird als eine Position innerhalb des Fahrzeugs jede Position der Ladeeinrichtung verstanden, die zur Konsequenz hat, dass die örtliche Lage der Ladeeinrichtung der des Fahrzeuges folgt. Als eine Position außerhalb wird verstanden, wenn dies nicht der Fall ist.

In einer ganz besonders vorteilhaften Ausführungsform kann die Ladeeinrichtung eine Gleichstrom-Ladeeinrichtung (DC-Ladeeinrichtung) umfassen, welche einen Gleichstrom abgibt oder aufnimmt, um das energiespeichernde Element zu laden. Hierbei kann eine Schaltungseinrichtung vorgesehen sein, die dazu eingerichtet ist, dass diese eine effiziente galvanische Trennung einer Anzahl N von bestimmten Energiespeichern untereinander und zugleich eine Ankopplung mit der Ladeeinrichtung erlaubt.

In einer alternativen Ausführungsform kann die Ladeeinrichtung eine Wechselstrom-Ladeeinrichtung (AC-Ladeeinrichtung) umfassen, welche einen Wechselstrom abgibt, um das energiespeichernde Element zu laden. Hierbei kann ein AC-DC-Umrichter (Gleichrichter) vorgesehen sein. Statt eines einzelnen Gleichrichters, der beispielsweise als AC-DC-Umrichter ausgestaltet ist, können auch mehrere Gleichrichter oder AC-DC-Umrichter parallelgeschaltet sein. Hierdurch können vorteilhaft beispielsweise eine Anzahl N von Energiespeichern mit der Ladeeinrichtung gekoppelt werden. Hierbei kann eine Schaltungseinrichtung vorgesehen sein, die dazu eingerichtet ist, dass diese eine effiziente galvanische Trennung einer Anzahl N von Energiespeichern sowohl vom Wechselstromnetz als auch untereinander und zugleich eine Ankopplung mit der Ladeeinrichtung erlaubt.

Darüber hinaus kann für eine DC-Ladeeinrichtung und/oder eine AC-Ladeeinrichtung eine Steuereinrichtung zum Steuern der Schaltungseinrichtung vorgesehen sein, die dazu eingerichtet ist, ein Koppeln von N bestimmten Energiespeichern mit der Ladeeinrichtung zu steuern. Die Steuerungseinrichtung erlaubt somit ein effizientes Schalten der Schaltungseinrichtung zum Austausch der Anzahl N Energiespeicher mit der Ladeeinrichtung und somit ein Fehler- und unterbrechungsfreies Laden der Fahrzeug-Energiespeicher sowie Ermitteln der Aufladungsdaten des Fahrzeug-Energiespeichers durch die Ladeeinrichtung.

In einer weiteren Ausführungsform umfasst die Ladeeinrichtung ein Element, welches dazu eingerichtet ist, einen Energiespeicher oder ein energiespeicherndes Element zu laden und/oder zu entladen.

Beispielsweise ist eine Ladeeinrichtung zum Entladen eines Energiespeichers so eingerichtet, sodass ein an das Ladegerät angeschlossener Energiespeicher oder angeschlossenes energiespeicherndes Element entladen werden soll, um vorteilhaft die enthaltene elektrische Energie zu reduzieren, so dass der einen Energiespeicher oder das energiespeichernde Element aus beispielsweise einem Fahrzeug entfernt werden kann und der Gefahr einer Explosion des Energiespeichers oder energiespeichernden Elements vorgebeugt wird.

Beispielsweise ist Ladeeinrichtung zum Laden eines Energiespeichers eingerichtet, sodass ein an das Ladegerät angeschlossener Energiespeicher oder angeschlossenes energiespeicherndes Element geladen werden kann. Der Ladevorgang kann hierbei über folgende vier Ladesysteme vorgesehen sein:
1. Ladegeräte mit stabilisierter Ausgangsspannung,
2. Impulsladegeräte,
3. Spannungsstabilisierende und strombegrenzende Ladegeräte,
4. Wechselspannungsladegeräte.

Die Bestimmung der Leistungsfähigkeit mittels des erfindungsgemäßen Verfahrens umfasst die direkte oder bevorzugt die indirekte Erfassung des Widerstands des energiespeichernden Elements, d.h. hier insb. die Berücksichtigung und/oder Entfernung von "parasitären" Einflüssen aus anderen, mitgemessenen Komponenten des Zwischenkreises oder von Verbindungselementen. Als ein Widerstand wird im Sinne der Erfindung ein elektrischer Widerstand und/oder Impedanz verstanden. Dabei handelt es sich um Maß dafür, welche elektrische Spannung (Volt) nötig ist, um eine bestimmte elektrische Stromstärke (Ampere) durch einen elektrischen Leiter (z.B. Kabel, Akkumulator) fließen zu lassen. Ein elektrischer Widerstand ist dann ein ohmscher Wirkwiderstand, wenn sein Wert unabhängig von der elektrischen Spannung und der Stärke des elektrischen Stromes und anderen Parametern (z.B. Frequenz) ist. Bei induktiven Elementen (z.B. Spule) oder kapazitiven Elementen (z.B. Kondensator, Akkumulator) ändert sich der Widerstand frequenzabhängig und zusätzlich zum ohmschen Anteil am Widerstand kommt ein Scheinwiderstand. Der gesamte Widerstand setzt sich aus dem ohmschen Wirkwiderstand und dem Scheinwiderstand zusammen und wird auch als Impedanz bezeichnet. Die Impedanz kann aus dem Verhalten des Stroms und der Spannung berechnet werden und wird hier synonym zu Widerstand verwendet. Der Widerstand einer energiespeichernden Einheit wie etwa einem Akkumulator hängt mit seiner Leistungsfähigkeit zusammen. Mit zunehmendem Alter bzw. Lade-/ Entladezyklen erhöht sich der Widerstand des Akkumulators und seine Leistungsfähigkeit sinkt. Demzufolge kann über eine Bestimmung des Widerstandes in zeitlichen Abständen auf die Leistungsfähigkeit geschlossen werden, bzw. die Leistungsfähigkeit näherungsweise ermittelt werden, insbesondere im zeitlichen Vergleich und/oder besonders vorteilhaft im Vergleich mit anderen Energiespeichern

In einer Ausführungsform ist die Ladeeinrichtung lösbar mit dem Fahrzeug verbunden. Dabei umfasst eine lösbare Verbindung im Sinne der Erfindung eine formschlüssige, kraftschlüssige oder stoffschlüssige Verbindung oder eine Kombination aus mindestens einer davon, die dazu geeignet ist die Ladeeinrichtung reversibel an dem Fahrzeug anzubringen.

In einer Ausgestaltung der Erfindung wird die Leistungsfähigkeit des energiespeichernden Elements bestimmt, ohne dass der Stromfluss zwischen der Ladeeinrichtung und dem Energiespeicher beeinflusst wird. So werden allein die Messgrößen (d.h. mindestens ein Strom und eine Spannung) ermittelt und verwendet, die zwischen einer Steuereinrichtung des Energiespeichers und der Ladestation, oder direkt einem Nutzer, bestimmt werden. Regelmäßig spricht hier der Fachmann von einer "Aushandlung", wobei der Ladesäule der Ladebedarf, ggf. auch der Entladebedarf, auf geeigneter Weise mitgeteilt wird, und diese entsprechend das Strom- bzw. Leistungsprofil ggf. unter Berücksichtigung von Grenzwerten einstellt. In einer Ausgestaltung der Erfindung wird der Widerstand, und damit in weiteren Schritten die Leistungsfähigkeit, des energiespeichernden Elements indirekt über eine Berechnung oder Approximation bestimmt, indem der abgegebene Stromfluss der Ladeeinrichtung so eingestellt wird, dass ein veränderlicher Stromanstieg oder Stromabfall (im Folgenden synonym als Stromanstieg bezeichnet) pro Zeiteinheit erreicht wird. Ein vorgegebener Stromanstieg pro Zeiteinheit umfasst bevorzugt zwischen 0,1 und 10,0 A pro Sekunde, besonders bevorzugt zwischen 0,1 und 1,0 A pro Sekunde und ganz besonders bevorzugt zwischen 0,3 und 0,8 A pro Sekunde. Der Stromanstieg kann von einer informationstechnischen Einheit vorgegeben werden, wobei die informationstechnische Einheit über eine Variation von Parametern die Ladezeit und/oder die Ladespannung und/oder den Ladestrom beeinflussen kann.

Bei der vorliegenden Erfindung hat sich als besonders vorteilhaft erwiesen, dass ein Ladestrom als positiv oder negativ gepolter Lade- oder Entladestrom impulsweise (d.h. veränderlicher Stromanstieg und Stromabfall, gefolgt von einer Haltedauer, gefolgt von einem Stromabfall oder Stromanstieg) an den Energiespeicher angelegt wird.

Die Haltedauer eines Ladeimpulses kann beispielsweise zwischen einer 1000stel bis maximal 600 Sekunden, vorzugsweise im Bereich zwischen einer 10tel und maximal 60 Sekunden betragen.

Es kann für die Bestimmung der Leistungsfähigkeit und insb. der Ermittlung von parasitären Anteilen und/oder Einflüssen, die nicht auf den Energiespeicher zurückzuführen sind, vorteilhaft sein, mehrere Impulse unterschiedlicher Haltedauer in unterschiedlichen zeitlichen Abfolgen ("Wartezeit"), sowie mit unterschiedlicher Stromanstiegs- oder Abfallgeschwindigkeit einzustellen. Es kann vorteilhaft sein, unmittelbar vorgenannte Zeiten und/oder Stromhöhen abhängig von der Leistungsfähigkeit des Energiespeichers und/oder Messwerten in der Ladestation, insb. der Spannung, einzustellen. Es kann vorteilhaft sein, das beschriebene Verfahren mehrfach gleich oder angepasst zu widerholen. Stets sind Strom und Spannung zu messen.

Die Stromstärke des Entlade- bzw. Ladeimpulses kann während des Verfahrens zur Bestimmung der Leistungsfähigkeit des Energiespeichers gezielt variiert werden und kann in Abhängigkeit des abgeschätzten Ladezustandes des Energiespeichers, der abgeschätzten Beschaffenheit des Energiespeichers bzw. auch in Abhängigkeit des abgeschätzten Zustandes des Energiespeichers in kleineren oder größeren Amplituden erfolgen und auch ggf. in kürzeren Stromzeiten, um hiermit die Präzision des Bestimmungsverfahrens bspw. anhand von hinterlegten Referenzmessungen zu erhöhen.

In einer bevorzugten Ausgestaltung wird daher mittels eines zeitlich veränderlichen Stroms ein Widerstand des Energiespeichers und/oder des Zwischenkreises bestimmt. Dieser kann bei einem Lade- oder Entladepulses veränderlich sein und ist beeinflusst durch sämtliche mit der Ladestation verbundene Komponenten (die auch zu den parasitären Effekten gezählt werden). Das Profil des zeitlich veränderlichen Stroms kann pulsweise veränderlich sein, wobei die Pausen zwischen den Pulsen gleich lang oder unterschiedlich lang sein können. Die Pulse können einem zugrundeliegenden Profil aufgelagert sein. Die Ausgestaltung des Stromprofils wird vorteilhafterweise so gewählt, dass parasitäre Einflüsse isoliert werden können und insbesondere Eigenschaften des Energiespeichers in den Vordergrund treten.

Darüber hinaus lassen sich steile Schaltflanken erzielen, sodass die Schaltverlustleistung sehr gering ist.

Bevorzugt setzt sich das erste Stromsignal aus gleichen Signalen zusammen, deren wellenförmiger (insbesondere sinusförmiger) oder rechteckiger oder anders ausgebildeter Verlauf zeitlich versetzt zueinander übertragen wird. Hierdurch kann der Ladezustand des Energiespeichers, die Beschaffenheit des Energiespeichers bzw. auch der Zustand des Energiespeichers abgeschätzt werden. Der Abgleich kann beispielsweise durch Vergleich der erhaltenen Daten mit Referenzwerten erfolgen.

Weiter kann die Steuerung des Beaufschlagens des Energiespeichers mit einem impulsweisen Lade- oder Entladestrom von einem Computer bzw. mit einem Prozessor eines Steuergeräts ausgeführt werden.

Es wird folglich auch ein System zur Datenverarbeitung vorgeschlagen, das einen Prozessor umfasst, der so angepasst/konfiguriert ist, dass er das Verfahren bzw. einen Teil der Schritte des vorgeschlagenen Verfahrens ausführt.

Unter einer informationstechnischen Einheit wird eine Entität verstanden, die in der Lage ist, elektronische Daten zu verarbeiten und/oder zu speichern und/oder diese weiterzuleiten und/oder diese optisch oder visuell wiederzugeben. Beispielsweise kann eine Ladeeinrichtung eine informationstechnische Einheit darstellen. Unter einer solchen ist auch ein peripheres Gerät (Adapter) umfasst, sofern dieser in der Lage ist, mindestens einen der beschriebenen Schritte durchzuführen.

Im Sinne der Erfindung ist unter einer Energieaufnahmefähigkeit die Eigenschaft des energiespeichernden Elements gemeint eine bestimmte elektrische Energie aufzunehmen oder abzugeben und diese zu speichern. Die Energieaufnahmefähigkeit steht im Zusammenhang mit der Ladungsaufnahmefähigkeit, das heißt der Fähigkeit eines Speichers, eine gewisse Ladungsmenge aufzunehmen oder abzugeben. Die Ladungsmenge, die ein Akkumulator oder eine Batterie speichern kann, kann in Amperestunden (Ah) angegeben werden und die maximal aufnehmbare Ladungsmenge wird auch als Kapazität (Nennkapazität) bezeichnet. Als eine Amperestunde ist die Ladungsmenge definiert, die innerhalb einer Stunde durch einen Leiter fließt, wenn der elektrische Strom konstant 1 A beträgt.

Die Energieaufnahmefähigkeit kann über das Verhältnis von Messdauer und durchschnittlicher Stromhöhe bestimmt werden. So kann beispielsweise ermittelt werden, in welchem Zeitraum (Messdauer) welche Strommenge (Stromhöhe) in den Akkumulator bis zu dessen maximaler Beladung geflossen ist.

Mit sich änderndem Ladungsinhalt ändert sich die Spannung des Energiespeichers auf eine charakteristische Art und Weise, sodass über das Vorliegen von eingespeister oder aufgenommener Ladungsmenge, Informationen über die Spannung und insbesondere die Änderung der Spannung über der Änderung der Ladungsmenge, des Energiespeichers, über den Zustand und Umgebungsinformationen (z.B. Temperatur, parasitäre Effekte) des Energiespeichers sowie über bekannte oder zu ermittelnde Zusammenhänge zwischen den genannten Größen auf die maximale Energieaufnahmefähigkeit und der zeitlichen Änderung und/oder der Vergleich mit anderen Energiespeichern möglich wird. Unter anderem ist das Vorliegen von Open Circuit Voltage-Charakteristiken ("OCV") der vorliegenden Energiespeicher vorteilhaft, die entweder vorermittelt und lokal oder in einer Cloud gespeichert werden können, oder sich über die Zeit aus der Berücksichtigung vieler Messungen ergeben, aus denen eine Statistik gebildet werden kann.

Demzufolge kann die Ladungsmenge/ Ladungsinhalt des Akkumulators ermittelt werden, indem der durchschnittliche Ladestrom mit der Ladezeit multipliziert wird.

Im Sinne der Erfindung wird unter einem Wirkungsgrad das Verhältnis/ der Quotient aus der vom energiespeichernden Element bei der Ladung aufgenommenen elektrischen Leistung und der bei der Entladung abgegebenen elektrischen Leistung verstanden. Wird der Quotient so gebildet, dass die abgegebene Leistung im Zähler steht, so ergibt sich für einen verlustfreien Akkumulator ein Wirkungsgrad von idealerweise 1, wenn die abgegebene Leistung der der aufgenommenen Ladeleistung entspricht. Mit zunehmendem Alter, sowie Lade- und Entladezyklen steigt der innere Widerstand des Akkumulators, wodurch ein Teil der aufgenommenen elektrischen Energie als Wärme verloren geht. Demzufolge verringert sich der Wirkungsgrad. Das Verhältnis der entnehmbaren zu der beim Laden aufzuwendenden Energie wird auch als Ladewirkungsgrad bezeichnet.

Bevorzugt werden parasitäre Einflüsse während des Verfahrens zur Bestimmung der Leistungsfähigkeit des Energiespeichers herausgerechnet.

Parasitäre Einflüsse (auch: parasitäre Widerstände oder parasitäre Impedanzen oder parasitäre Umgebungsbedingungen) umfassen im Sinne der Erfindung physikalische Einflüsse, die nicht auf das energiespeichernde Element zurückzuführen sind sondern bspw. auf solche im elektrischen Versorgungspfad eines Fahrzeugs, bspw. dem Zwischenkreis oder Komponenten dessen, sowie Übergangswiderstände, Stecker, Verbindungselemente, aktive und passive Bauteile, Kabel und Leitungen. So wäre beispielsweise der Innenwiderstand des Akkumulators nicht als ein parasitärer Einfluss anzusehen, jedoch aber beispielsweise Leitungswiderstände der Leistungskanäle, außerhalb des Akkumulators auftretende Impedanzen im Stromkreis, Steckerwiderstände, oder Gegeninduktionen räumlich benachbarter Stromkreise. Dem Fachmann ist bekannt, welche Einflüsse von parasitären Einflüssen umfasst sind, welche von den sogenannten Zwischenkreise umfasst sind.

Ebenso als parasitär angesehen werden Umgebungsbedingungen, die Einfluss auf die Widerstände und/oder die Energieaufnahmefähigkeit haben, wie die Temperatur oder die Temperaturverteilung innerhalb des Energiespeichers, oder des elektrischen, elektrochemischen, chemischen oder thermischen Gleichgewichtszustandes, bzw. der Erreichungsgrad dessen.

Beispielsweise können Informationen über parasitäre Impedanzen im elektrischen Versorgungspfad eines Fahrzeugs ermittelt werden, indem das Ladegerät über zwei stromführende Leistungskanäle (Anschlüsse) mit je einem Pol eines Zwischenkreises, an dem der Energiespeicher angeschlossen ist, verbunden ist. Dem Fachmann sind Methoden bekannt, Informationen über Impedanzen aus bekannten Impedanzen des Ladegeräts, sowie der Spannungsantwort des Messobjektes auf eine geeignete, dynamische und/oder transiente Stromanregung zu gewinnen. So kann in einer Ausführungsform zunächst ein erster Spannungsabfall an den zwei Anschlüssen in einem hochohmigen Zustand des Ladegeräts ermittelt werden, danach ein zweiter Spannungsabfall an den zwei Anschlüssen in einem niederohmigen Zustand des Ladegeräts jeweils bei einem definierten Stromfluss ermittelt werden und im Anschluss der parasitäre Widerstand aus dem ersten Spannungsabfall, dem zweiten Spannungsabfall und der Stromstärke ermittelt werden. In einer alternativen Ausführungsform kann auch zunächst ein erster Spannungsabfall an den zwei Anschlüssen in einem niederohmigen Zustand des Ladegeräts ermittelt werden und danach ein zweiter Spannungsabfall in einem hochohmigen Zustand des Ladegeräts ermittelt werden.

Beispielsweise können Informationen über parasitäre Impedanzen, und daher auf die Impedanz und damit - wie beschrieben - Leistungsfähigkeit des Energiespeichers, auch dadurch ermittelt oder abschätzt werden, indem das Verhalten der Spannung an/in der Ladestation und/oder am Zwischenkreis und/oder zwischen den Leistungskanälen hinsichtlich des diffusions- bzw. interkalations-bedingten Impedanzverhaltens, insbesondere Relaxationsverhaltens, untersucht wird. So ist es bekannt, dass typische Energiespeicher, insbesondere Li-lonen-Akkumulatoren, auf der Diffusion oder Interkalation von Ladungsträgern in eine(r) Elektrode beruhen. Diese Vorgänge machen sich durch ein charakteristisches Verhalten der Spannung als Antwort auf Stromfluss bemerkbar, welche so wenige andere bekannte elektrische Bauteile aufweisen. Die Existenz dieses Phänomens beschrieb schon Emil Warburg im Jahre 1899 Da man in typischen Fahrzeugtopologien davon ausgehen kann, dass ausschließlich der Energiespeicher dieses Verhalten aufweist (und etwa ein Elektromotor am Zwischenkreis nicht), kann aus einer Suche, Erkennung und Auswertung dieser Phasen isoliert auf die Eigenschaften des - und nur des - Energiespeichers geschlossen werden, auch wenn die gemessene Spannung und/oder der gemessene Strom das Gesamtsystem repräsentieren, also auch die Einflüsse anderer Komponenten, wie parasitären Effekte, umfasst.

Vorteilhafterweise können Informationen hier aus der zeitlichen Veränderung der Spannung ("Relaxation") nach (fast) vollständiger Beendigung von Stromflüssen, und/oder nach einer abrupten Änderung der Stromstärke in oder aus dem Energiespeicher ermittelt werden.

Der Stromfluss im niederohmigen Zustand kann auf verschiedene Art und Weise erzeugt werden. Beispielsweise kann in das Ladegerät ein Teststrom eingespeist werden. Gemäß einer anderen Variante kann ein dem Ladegerät zugeordneter Verbraucher eingeschaltet werden, um den Stromfluss zu erzeugen. Im zuletzt genannten Fall können sich beim Ermitteln des entsprechenden Spannungsabfalls alle übrigen elektrischen Verbraucher des Fahrzeugs im Ruhezustand befinden.

Die Bestimmung der Leistungsfähigkeit mittels des erfindungsgemäßen Verfahrens kann entweder vor Ort approximiert werden (lokale Vorberechnung) und/oder dezentral innerhalb eines cloudbasierten informationstechnischen Systems berechnet werden. Als eine Position vor Ort wird eine Position in näherer Umgebung des Fahrzeugs, bevorzugt in einem Radius innerhalb von 50 Metern, besonders bevorzugt innerhalb eines Radius von 20 Metern und ganz besonders bevorzugt innerhalb eines Radius von 5 Metern verstanden. Weiterhin wird als eine Position vor Ort eine Position verstanden, welche sich im gleichen Gebäude befindet wie das Fahrzeug.

Vorteilhaft bewirkt eine Approximation vor Ort, beispielsweise über einen Mikrocontroller, eine schnelle Bestimmung der Leistungsfähigkeit des Akkumulators auch bei Nichtvorhandensein einer Internetverbindung. In einer weiteren Ausführungsform kann eine genauere Berechnung in einem cloudbasierten informationstechnischen System (Cloud) erfolgen, was eine Internetverbindung voraussetzt. Der Kommunikationsweg zwischen der Vorrichtung zur Bestimmung der Leistungsfähigkeit/ der informationstechnischen Einheit zur Cloud kann eine Kabelverbindung (z.B. Ethernet-Kabelverbindung) sowie eine Funkverbindung (z.B. LTE, 4G, 5G) oder eine Verbindung über WLAN umfassen.

In einer alternativen Ausführungsform ermöglicht der Zugriff einer oder mehrerer informationstechnischer Einheiten auf die Cloud die Einbeziehung dort hinterlegter (gespeicherter) Daten zu einem oder mehr als einem Akkumulator-Typ, der in einem oder mehr als einem Fahrzeug verbaut ist. Die hinterlegten Daten können auch in einer anderen informationstechnischen Einheit (z.B. Smartphone, Notebook, Festplatte, USB-Stick) gespeichert sein.

Erfindungsgemäß umfasst ein dezentrales cloudbasiertes informationstechnisches System (Cloud) ein solches, welches ermittelte Messwerte (z.B. Spannung, Strom, Temperatur, Feuchte) mittels zumindest einer informationstechnischen Einheit empfängt, verarbeitet, speichert, überträgt oder versendet, oder einer Kombination aus mindestens einem davon. Im Sinne der Erfindung umfassen Messwerten physikalische Größen, die sich entweder direkt oder indirekt von den SI-Einheiten ableiten lassen. Messwerte umfassen beispielsweise Temperatur, Zeit, Entfernung (z.B. Laufleistung in km) Stromstärke, Spannung, Feuchtigkeit, Beschleunigung, Geschwindigkeit. Erfindungsgemäß können physikalische Größen auch geschätzt werden, wobei bestimmte physikalische Größen herangezogen werden, um eine andere physikalische Größe zu schätzen. Beispielsweise kann mit Hilfe eines Thermometers, bspw. eines kontaktlosen Thermometers, besonders vorteilhaft eines Infrarotthermometers, welches unterhalb eines in der Ladestation befindlichen Fahrzeugs angeordnet ist, mindestens eine, vorteilhaft mehrere räumlich verteilte, Temperaturen des Gehäuses des Energiespeichers ermittelt werden. Vorteilhaft kann so Erkenntnis über die Temperaturverteilung des Energiespeichers geschätzt werden, ohne auf fahrzeuginterne Systeme zugreifen zu müssen, was einem Dritten nicht möglich ist. Vorteilhaft kann so auf das thermische, elektrochemische, chemische und/oder thermodynamische Gleichgewicht des Energiespeichers geschlossen werden.

Die Ermittlung von Messwerten kann direkt oder indirekt an mindestens einem Fahrzeug und/oder Akkumulator, und/oder Ladeeinrichtung, und/oder weiteren Element (z.B. Adapter) erfolgen. Die Ermittlung von Messwerten erfolgt in zeitlichen Abständen zueinander. Dabei umfasst ein Zeitraum der Messung beispielsweise die Nutzungszeit des Akkumulators. Als ein Zeitraum wird auch die zeitliche Differenz von einer älteren zu einer jüngeren Messung verstanden. In einer Ausführungsform erfolgt eine Messung zu einem Zeitpunkt, wobei die erhaltenen Messwerte gespeichert werden, um diese beispielsweise bei einer späteren Messung abrufbar zu machen.

Vorteilhaft ermöglicht die Erfassung von verschiedenen Messwerten eine differenzierte Bestimmung der Leistungsfähigkeit des energiespeichernden Elements und eine Prognose der zu erwartenden Entwicklung der Leistungsfähigkeit.

In einer Ausführungsform der Erfindung kann die Umgebungstemperatur und/oder Oberflächentemperatur des Fahrzeugs und/oder energiespeichernden Elements ermittelt werden, um Rückschlüsse auf die Temperatur oder den Gleichgewichtszustands des energiespeichernden Elements zu erlauben. Insbesondere kann auch die Kerntemperatur des energiespeichernden Elements ermittelt werden Weiterhin kann auch die Oberflächentemperatur des Fahrzeugbodens ermittelt werden. Durch die Ermittlung von Oberflächentemperaturen oder die Ermittlung von Umgebungswerten können vorteilhaft parasitäre Einflüsse berechnet oder geschätzt werden, die einen Einfluss auf die Widerstandsmessung haben.

In einer Ausführungsform kann eine informationstechnische Einheit die Stärke des Ladestroms und/oder der Ladespannung abhängig von einem oder mehr als einem Messwert anpassen.

Erfindungsgemäß wird unter der Stillstandzeit der Zeitraum verstanden, in der das Fahrzeug nicht bewegt wird, wohingegen die Fahrzeit den Zeitraum beschreibt, in der das Fahrzeug bewegt wird, während die Betriebszeit den Zeitraum beschreibt, in welchem Energie aus dem Energiespeicher entnommen oder aufgenommen wird. Davon zu unterscheiden ist die Laufzeit, die den Zeitraum beschreibt, in dem eine Entladung des Akkumulators stattfindet, ohne dass das Fahrzeug bewegt wird. Vorteilhaft erlaubt die Ermittlung dieser Messwerte/ Zeiten weitere Aussagen über die zu erwartende Leistungsfähigkeit des energiespeichernden Elements, indem diese Messwerte einzeln oder kombiniert mit weiteren Messwerten eine Approximation oder Berechnung der Leistungsfähigkeit eines energiespeichernden Elements erlauben. Vorteilhaft kann die Bestimmung der Stillstandszeit dazu dienen abzuschätzen, wie weit der Energiespeicher von seinem thermischen, chemische, elektrochemischen und/oder thermodynamischen Gleichgewicht entfernt ist, was einen Einfluss auf die Widerstandsmessung hat. In einer Ausführungsform werden die Messwerte in periodischen Abständen erhoben, wobei eine informationstechnische Einheit die Abstände bestimmen kann.

In einer Ausgestaltung umfasst die Cloud hinterlegte Daten (Lookup-Tabellen) zu den Spezifikationen der unterschiedlichen Akkumulatoren. Eine Lookup-Table umfasst Daten bezüglich der Ladevorgänge, sowie auch Referenzdaten der Akkumulator-Hersteller. Die Daten können von den Herstellern bezogen werden, welche die entsprechenden Kennzahlen (z.B. Nennspannung, Kapazität) publizieren. In einer alternativen Ausführungsform sind in der Cloud die Kennzahlen zu mehr als einem Fahrzeug und/oder mehr als einer energiespeichernden Einheit hinterlegt. In einer besonders bevorzugten Ausgestaltung dienen die in der Cloud hinterlegten Daten der Erstellung einer Statistik, welche der Beurteilung der Leistungsfähigkeit zugrunde liegt. In einer Weiterbildung umfasst die Statistik anfangs hinterlegte Daten zu dem energiespeichernden Element, beispielsweise Daten des Herstellers, wobei die Statistik um gesammelte Daten erweitert wird, um die Leistungsfähigkeit besser beurteilen zu können.

In einer bevorzugten Ausführungsform gleicht mindestens eine informationstechnische Einheit die in der Cloud hinterlegten Daten mit den ermittelten Messwerten ab. In einer besonders bevorzugten Ausführungsform gelangen die Daten von der Cloud auf ein oder mehrere mobile Telekommunikationsgeräte (z.B. Smartphone, Tablet, Notebook), welches eine graphische Anzeige der Daten ermöglicht. In einer weiteren Ausführungsform werden die ermittelten Messwerte an die Cloud übertragen und dort mit den Messwerten anderer Akkumulatoren verglichen.

In einer besonders bevorzugten Ausgestaltung sind in der Cloud die Information zu jedem einzelnen Akkumulator hinterlegt, welcher über eine Ladeeinrichtung, die direkt oder indirekt mit der Cloud verbunden ist, geladen wird. Dies ermöglicht es vorteilhaft, dass ein Algorithmus und/oder bevorzugt eine künstliche Intelligenz (KI), die Zugriff auf die Cloud hat, entscheiden kann, welcher Akkumulator mit welchen Ladespannungen und/oder Ladeströmen und/oder Ladezeiten geladen wird. Die KI kann also optimale Ladekurven ermitteln. Vorteilhaft ergibt sich daraus, dass die KI anhand einer Modellbildung aufgrund der sich über die Zeit für jeden Akkumulator unterschiedlich entwickelnden Messwerte die Parameter bestimmen kann, welche eine optimale Leistungsfähigkeit des Akkumulators zur Folge hat. Dabei muss die KI darauf achten, dass sie die Parameter nur in einem begrenzten Bereich variiert, so dass kein Kunde eine intolerable durch die KI herbeigeführte negative Beeinträchtigung der Leistungsfähigkeit hinnehmen muss. Vorteilhaft ergibt sich daraus eine verbesserte Leistungsfähigkeit des energiespeichernden Elements.

In einer weiteren Ausführungsform werden nicht nur die Messwerte der Akkumulatoren in der Cloud hinterlegt und/oder von einer KI prozessiert, sondern zusätzlich weitere, auf das Fahrzeug bezogene, Messwerte wie beispielsweise Geschwindigkeit und Stillstandzeiten ermittelt und verarbeitet. Dabei stammen die Messwerte bevorzugt von mehr als einem, besonders bevorzugt mehr als Tausend und ganz besonders bevorzugt mehr als einer Million Fahrzeugen und/oder energiespeichernden Elementen.

Bevorzugt werden die Messwerte von einer Messvorrichtung erhoben, die mit dem Fahrzeug und/oder dem energiespeichernden Element und/oder einem Adapter und/oder der Ladeeinrichtung verbaut ist und der Ermittlung physikalischer Größen (z.B. Temperatur, Spannung, Strom, Beschleunigung, Geschwindigkeit) dient. So kann als eine Messvorrichtung beispielsweise mindestens ein wärmeabhängiger Widerstand (z.B. NTC-Widerstand, PTC-Widerstand) oder eine kontaktlose Temperaturmessvorrichtung (z.B. ein Infrarotthermometer) dienen, der sich auf und/oder neben und/oder innerhalb des energiespeichernden Elements befindet und der Messeinrichtung über eine elektrische Schaltung Informationen übermittelt. Eine Messvorrichtung ist im Sinne der Erfindung nicht als ein einzelnes Element zu verstehen. Stattdessen umfasst die Messvorrichtung alle Elemente, die eine physikalische Größe erfassen, wobei die Messwerte gleichzeitig und/oder nicht gleichzeitig erfasst werden können.

In einer Ausgestaltung kann sich unterhalb des Fahrzeugs eine Matte befinden, in welcher Temperatursensoren, bspw. kontaktlose, angeordnet sind, um über die Messung und mit Hilfe der Statistik Rückschlüsse auf mindestens eine repräsentative Temperatur, bspw. der durchschnittlichen Innentemperatur oder der Temperaturverteilung des energiespeichernden Elements zu erlauben.

In einer bevorzugten Ausführungsform wird das erfindungsgemäße Verfahren mit einem Adapter umgesetzt, der eine Ausgestaltung einer informationstechnischen Einheit darstellt, wobei in diesem eine oder mehrere Messvorrichtungen integriert sind. Vorteilhaft hat der Adapter Kontrolle über die von der Ladeeinheit abgegebene Stromstärke. Dies ist besonders vorteilhaft, wenn die Ladeeinheit selbst keinen Kontakt zu einer Cloud herstellen kann, aber der Adapter. Dieser kann dann auf die hinterlegten Daten zugreifen und regelt die abhängig von diesen die Ladezeit und/oder die Ladespannung und/oder den Ladestrom.

Eine Ausführungsform des erfindungsgemäßen Verfahrens zur Bestimmung der Leistungsfähigkeit von elektrischen Fahrzeug-Energiespeichern umfasst zur Bestimmung der Leistungsfähigkeit die Ermittlung des Ladezustandes (state of charge, SoC) des energiespeichernden Elements (z.B. Akkumulator). Der SoC ist ein Kennwert für den Ladezustand von Akkumulatoren. Der SoC-Wert kennzeichnet die noch verfügbare Ladungsmenge eines Akkumulators im Verhältnis zum Nominalwert. Der Ladezustand wird in Prozent vom vollgeladenen Zustand angegeben. Beispielsweise bedeutet ein SoC von 30 %, dass der Akkumulator noch eine Restladungsmenge von 30 % bezogen auf die ursprüngliche Vollladung von 100 % hat. Mit Kenntnis oder Schätzung des SoC kann vorteilhaft die Energiespeicherfähigkeit ermittelt werden.

In einer weiteren Ausführungsform kann die Information über den Ladezustand von einer zusätzlichen Kommunikationsschnittstelle zwischen Fahrzeug und Ladestation übermittelt werden, wobei die zusätzliche Kommunikationsschnittstelle einen Adapter umfassen kann. Im Sinne der Erfindung umfasst eine Kommunikationsschnittstelle auch das Ladekabel oder der Fahrzeugführer, der eine manuelle Eingabe, also eine manuelle Übertragung von Daten an beispielsweise eine Ladeeinrichtung vornimmt.

In einer alternativen Ausführungsform stellt der Adapter eine Verbindung zur Cloud her, um mit diesen Daten auszutauschen oder in diese Daten zu speichern. In einer bevorzugten Ausführungsform stellt der Adapter für einen Datenaustausch eine Verbindung zu einem oder mehreren mobilen Telekommunikationsgeräten (z.B. Smartphone, Tablet, Notebook) und/oder einer technischen Einheit, die informationstechnische Signale verarbeiten, her. Eine zusätzliche Kommunikationsschnittstelle erlaubt vorteilhaft, dass die Ladeeinrichtung nicht auf das Battery Management System (BMS) abgestimmt sein muss. Stattdessen bewirkt die zusätzliche Kommunikationsschnittstelle einen korrekten Datenaustausch des BMS mit der Ladeeinrichtung und/oder mindestens einer weiteren informationstechnischen Einheit.

In einer besonders bevorzugten Ausgestaltung umfassen die ermittelten Messwerte zu der energiespeichernden Einheit beispielsweise physikalische Größen wie Spannung, Strom (insbesondere Stromspitzen), Temperatur, Temperaturschwankungen, Feuchte sowie Alter des Akkumulators. Messwerte können weiterhin die Fahrzeugbewegung, insbesondere die Beschleunigung, umfassen. Vorteilhaft kann unter Zuhilfenahme einer Kombination einzelner Messwerte eine präzisere Berechnung der Leistungsfähigkeit des energiespeichernden Elements erreicht werden.

Unter dem Alter des energiespeichernden Elements wird der Zeitraum von seiner Erstnutzung bis zum aktuellen Zeitpunkt der Verwendung verstanden. Das Alter eines Akkumulators erlaubt vorteilhaft eine differenziertere Bestimmung der Leistungsfähigkeit des energiespeichernden Elements.

In einer alternativen Ausführungsform können Teile der Messwerte von einer Diagnoseschnittstelle, einem Head-Up-Display oder einem Armaturenbrett oder einer Kombination davon, ausgelesen werden. Das Auslesen kann von einer informationstechnischen Einheit bewerkstelligt werden. Optional kann das Auslesen derart erfolgen, dass der Fahrzeugführer die Messwerte manuell an eine informationstechnische Einheit überträgt.

In einer Ausführungsform kann das Fahrzeug und/oder das energiespeichernde Element mittels eines Identifikationsverfahrens eindeutig identifiziert werden. Dem Fachmann sind aus dem Stand der Technik verschiedene Möglichkeiten bekannt, Gegenstände, insbesondere elektronische Systeme (z.B. das Fahrzeug, der Akkumulator) sowie informationstechnische Systeme mit einer Kennung zu versehen, die von einer informationstechnischen Einheit ermittelt und prozessiert werden kann (z.B. auf einem RFID-Chip gespeicherte Daten). In einer bevorzugten Ausgestaltung wird die Kennung an den Adapter und/oder die Ladeeinrichtung und/oder die Cloud und/oder das mobile Kommunikationsgerät übermittelt. In einer besonders bevorzugten Ausgestaltung umfassen das Fahrzeug, und/oder das energiespeichernde Element, und/oder der Adapter, und/oder die Ladeeinrichtung und/oder die Cloud und/oder das mobile Kommunikationsgerät eine Kennung. Im Sinne der Erfindung umfasst eine Kennung einen numerischen Wert wie beispielsweise 283163849. Die Kennung kann auf der Einheit, die sie identifiziert, sichtbar aufgebracht sein, und/oder informationstechnisch gespeichert sein. Eine Kennung umfasst weiterhin eine Fahrzeugidentifikationsnummer, eine MAC-Adresse, oder das Kennzeichen des Fahrzeugs.

In Ausführungsform erfolgt die Identifikation des Fahrzeugs und/oder des energiespeichernden Elements durch eine Nutzereingabe des Anwenders auf einem Display. Das Display überträgt die eingegebene Information an eine informationstechnische Einheit für die Prozessierung. In einer bevorzugten Ausgestaltung umfasst die Ladeeinrichtung ein Display. Zudem kann das Display ein Teil des Fahrzeugs, des mobilen Kommunikationsgerätes, oder des Adapters sein. Alternativ kann eine Identifikation über eine Ladekarte erfolgen, die in die Ladeeinrichtung eingeführt wird.

In einer alternativen Ausführungsform erfolgt die Identifikation des Fahrzeugs und/oder des energiespeichernden Elements und/oder des Fahrzeugführers/Anwenders über eine Kamera. So kann die Kennung beispielsweise derart gestaltet sein, dass das Kfz-Kennzeichen oder der Gesichtsabdruck des Fahrzeugführers in einem informationstechnischen System (z.B. der Cloud) hinterlegt ist, wobei gleichzeitig die Daten zu dem Fahrzeug und/oder der energiespeichernden Einheit hinterlegt sind. Vorteilhaft muss der Fahrzeughalter somit keine manuelle Eingabe tätigen. Alternative Ausführungsformen nutzen beispielsweise einen Iris-Scan und/oder einen Fingerabdruck des Fahrzeugführers.

In einer weiteren Ausführungsform erfolgt die Identifikation des Fahrzeugs und/oder des energiespeichernden Elements mittels Plug and Charge oder Autocharge oder OCCP. Bei mit diesen Verfahren arbeitenden Ladeeinrichtungen werden Ladevorgänge einfach durch einfaches Anschließen bzw. Trennen des Ladekabels gestartet oder beendet. Damit erübrigt sich die Verwendung einer Ladekarte zur Identifikation. Bei beiden handelt es sich um standardisierte Ladeverfahren, welche eine zusätzliche Kommunikationsschnittstelle und zumindest eine Identifikationsmöglichkeit bieten.

In einer Ausführungsform wird für die Bestimmung der Leistungsfähigkeit die Energieaufnahmefähigkeit ermittelt, d.h. in welcher Zeitspanne das energiespeichernde Element den maximalen Ladungsinhalt erreicht. Dies ist aus dem Grund relevant für die Bestimmung, da sich mit zunehmendem Alter eines Akkumulators dessen Fähigkeit, eine definierte Ladungsmenge in einer vorgegebenen Zeit zu speichern, verschlechtert. Angenommen ein neuwertiger und ein älterer Akkumulator des gleichen Modells würden mit der gleichen Ladespannung geladen, wobei sich der Strom entsprechend dem Widerstand einstellt. Während der neuwertige Akkumulator beispielsweise einen Ladungsinhalt von 100 kWh innerhalb von 10 Stunden erreicht, erreicht ein alter Akkumulator beispielsweise einen Ladungsinhalt von 90 kWh innerhalb von 13 Stunden. Seine Leistungsfähigkeit ist also schlechter. Daher kann die Erfassung dieser Zeitspanne der Bestimmung der Leistungsfähigkeit dienen.

### Ausführungsbeispiele

Anhand folgender Figuren und Ausführungsbeispiele wird die vorliegende Erfindung näher erläutert, ohne die Erfindung auf diese zu beschränken.

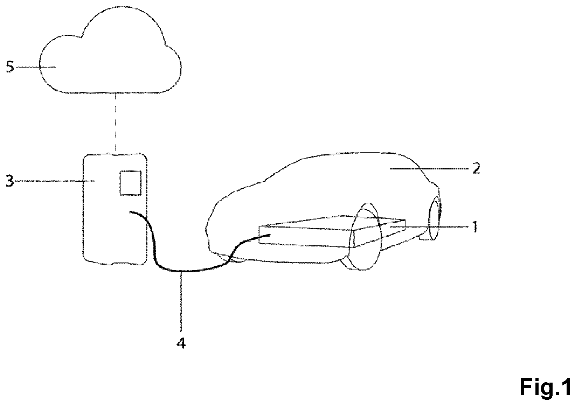

**Fig. 1** In einem ersten Ausführungsbeispiel umfasst das erfindungsgemäße Verfahren ein elektrisch betriebenes Fahrzeug EV (electric vehicle) **2** mit einem elektrischen Energiespeicher **1,** eine Ladeeinrichtung **3,** welche lösbar mit dem elektrischen Energiespeicher **1** über ein Ladekabel **4** verbunden ist. Eine Vorrichtung zur Bestimmung der Leistungsfähigkeit ist dabei in die Ladeeinrichtung **3** integriert und kommuniziert über einen zusätzlichen Kommunikationsbus, welcher kombiniert mit dem Ladekabel **4** ausgeführt ist, mit dem elektrischen Energiespeicher **1** und über einen zweiten Kommunikationsweg mit einem Cloud-Server **5.**

In dieser Ausführungsform ist der Energiespeicher aus einem Lithium-Ionen-Akkumulator gebildet, wobei die Leistungsfähigkeit des elektrischen Energiespeichers **1** in Zusammenhang mit dem Widerstand und der Energieaufnahmefähigkeit des Energiespeichers **1** steht und wobei die Leistungsfähigkeit mit SoH (State of Health) abgekürzt wird und wobei der elektrischer Energiespeicher **1** aus parallel und in Reihe geschalteten Akkumulator-Zellen besteht.

In dieser Ausführungsform ist der Datenübertragungsbus zwischen der Vorrichtung zur Bestimmung der Leistungsfähigkeit und dem elektrischen Energiespeicher 1 als serielle Schnittstelle ausgeführt und verwendet den Übertragungsstandard CAN-Bus. Die Vorrichtung zur Bestimmung der Leistungsfähigkeit greift dadurch auf Sensorwerte des Fahrzeugs und des elektrischen Energiespeichers wie Ladestrom, Ladespannung, SOC (state of charge), und die Zell-Temperatur im Inneren des elektrischen Energiespeichers 1 zu, sofern diese vom Hersteller freigegeben sind. Zusätzlich werden historische Daten des elektrischen Energiespeichers **1,** wie Ladezyklen und Laufleistung des Fahrzeugs, Stillstandzeit des Fahrzeugs, Temperaturverlauf des Fahrzeug-Bodens sowie des Fahrzeug-Umfeldes an die Vorrichtung zur Bestimmung der Leistungsfähigkeit übertragen.

Dabei werden die Daten während des Ladevorgangs, welche Strom, Spannung, SOC und Temperatur im Inneren des elektrischen Energiespeichers **1** umfassen, während des Ladevorgangs in Echtzeit durch die Vorrichtung zur Bestimmung der Leistungsfähigkeit, erfasst.

Für die Identifikation und Zuordenbarkeit von elektrischen Energiespeichern **1** und Fahrzeugen **2** wird ein eindeutiges Identifikationsverfahren angewendet. Die Identifikationsmerkmale werden dabei über die zusätzliche Kommunikationsschnittstelle für die Kennung übermittelt. Alternativ dazu erfolgt die Identifikation von Fahrzeugen und elektrischen Energiespeichern durch Nutzereingabe oder durch Bilderkennung mittels Kamera oder durch Plug and Charge oder durch Autocharge.

Der Kommunikationsweg zwischen der Vorrichtung zur Bestimmung der Leistungsfähigkeit und dem Cloud-Server ist durch eine Ethernet-Kabelverbindung eingerichtet.

In dem vorliegenden Ausführungsbeispiel werden die Ladedaten und historischen Daten verschiedener elektrisch betriebener Fahrzeuge **2** und elektrischer Energiespeicher auf dem Cloud-Server in einem Lookup-Table gespeichert. Diese Daten werden von der Vorrichtung zur Bestimmung der Leistungsfähigkeit abgerufen und werden nach jedem Ladevorgang um die dabei gemessenen Ladedaten und historische Daten ergänzt.

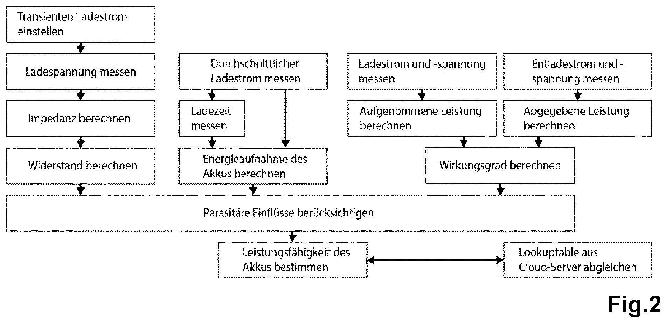

**Fig. 2** In dem vorliegenden Ausführungsbeispiel werden parasitäre Einflüsse der Ladeeinrichtung und des elektrischen Energiespeichers berücksichtigt. Dabei umfassen diese parasitären Einflüsse etwa Kabelwiderstände und Gegeninduktion, Energieverbrauch durch Nebenverbraucher und Übergangswiderstände.

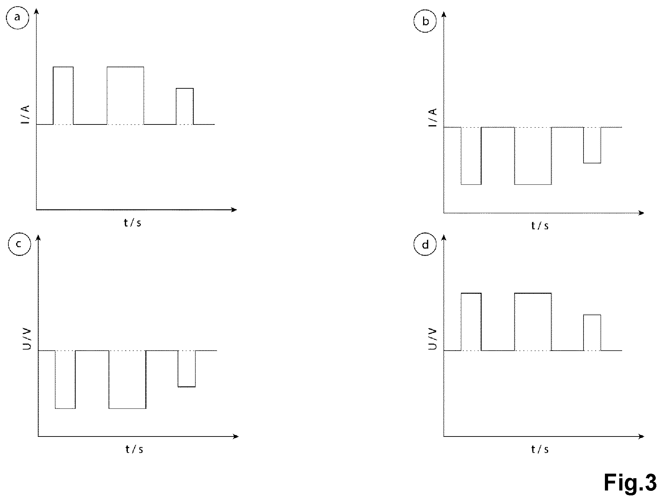

Für die Bestimmung der Leistungsfähigkeit eines Energiespeichers **1** wird der Ladestrom gepulst eingestellt. Dabei wird die Pulsweite oder die Amplitude des Pulses veränderlich eingestellt **(****Fig. 3a****).** Bei der Belastung des Energiespeichers wird der Strom ebenfalls mit variabler Pulsweite oder -amplitude eingestellt **(****Fig. 3b****).** Anstelle des Stroms kann auch die Lade- und Entladespannung zeitlich veränderlich mit variabler Pulsweite oder -amplitude eingestellt werden **(****Fig. 3c und 3d****).**

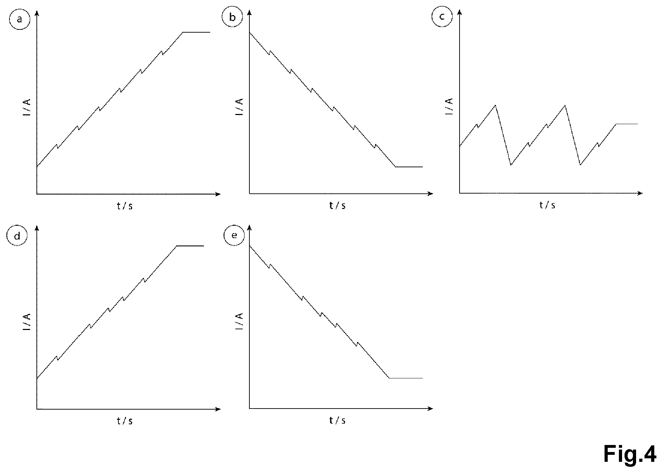

Für die Bestimmung des Widerstandes des elektrischen Energiespeichers **1** beim Laden wird ein transienter (zeitveränderlicher) Ladestrom von der Ladeeinrichtung eingestellt, wie in **Fig. 4** dargestellt. Dabei steigt der Ladestrom in **Fig. 4a** mit einem vorgegebenen Anstieg und fällt mit kleinen, regelmäßigen Abstiegen bis er eine vorgeschriebene Stromstärke erreicht. Aus der Antwort der Spannung wird die Impedanz und daraus der Widerstand des elektrischen Energiespeichers **1** bestimmt. Anschließend werden die entsprechenden parasitären Widerstände berücksichtigt. Anhand eines vermessenen Referenz-Energiespeichers werden zu den bestimmten Widerständen, i.A. Messwerten, entsprechende Ladungsinhalte angegeben, woraus auf die Leistungsfähigkeit geschlossen wird, wie in **Fig. 5a** gezeigt. Dabei ergeben die historischen Referenzwerte eine Streubreite, welche durch die gestrichelten Linien dargestellt ist. Je mehr Referenzwerde vorhanden sind, desto genauer fällt das Ergebnis aus. In **Fig. 5b** werden die Messwerte eines anderen Energiespeichers mit den Referenzwerten verglichen, um auf dessen Leistungsfähigkeit zu schließen.

Alternativ wird für die Bestimmung der Ladungsmenge des elektrischen Energiespeichers der durchschnittliche Ladestrom mit der Ladezeit multipliziert. Anschließend werden die entsprechenden parasitären Einflüsse berücksichtigt. Für die Berechnung eines Wirkungsgrades eines elektrischen Energiespeichers wird die Entladungsmenge ins Verhältnis zur Ladungsmenge gesetzt.

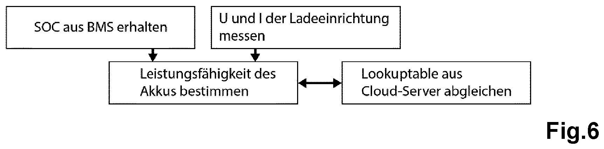

**Fig. 6** In einem weiteren Ausführungsbeispiel werden in Ergänzung zu dem ersten Ausführungsbeispiel weitere Messwerte zur Bestimmung der Leistungsfähigkeit elektrischer Energiespeicher **1** berücksichtigt. Dabei ist ein weiterer Messwert der SOC des elektrischen Energiespeichers **1.** Dabei wird der SOC über eine Kommunikationsschnittstelle von dem BMS (battery management system) an die Vorrichtung zur Bestimmung der Leistungsfähigkeit übermittelt.

Eine weitere Möglichkeit zur Bestimmung des SOC besteht im Messen der Ladespannung und des Ladestroms, dabei werden diese Messwerte mit Referenzwerten eines neuwertigen elektrischen Referenz-Energiespeichers aus einem Lookup-Table von einem Cloud-Server verglichen. Dabei hält der Lookup-Table auf dem Cloud-Server neben den Referenzwerten historische Ladedaten und Identifikationsmerkmale von Fahrzeugen und elektrischen Energiespeichern.

Der maximale Stromfluss eines neuwertigen elektrischen Referenz-Energiespeichers muss dabei 0,25 1/h des maximalen Ladungsinhaltes betragen.

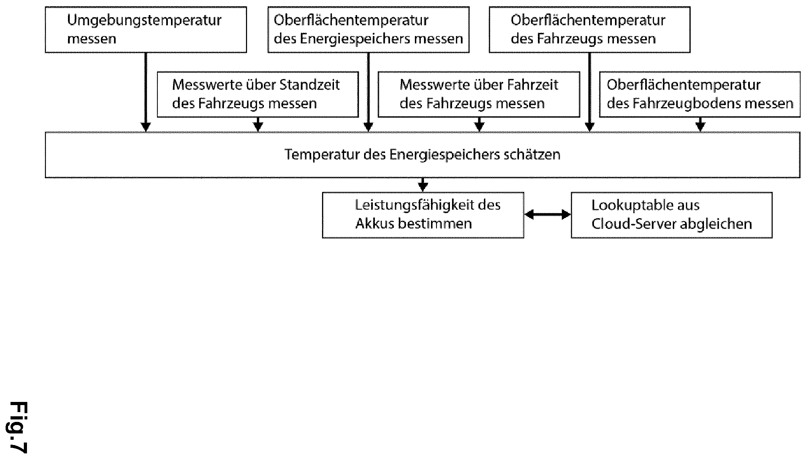

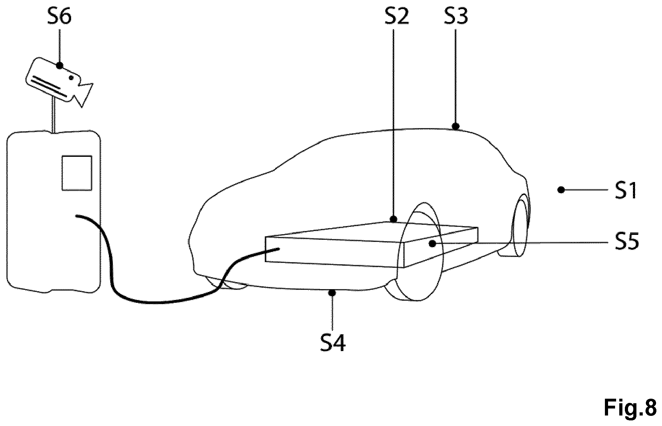

**Fig. 7** Ein weiteres Ausführungsbeispiel berücksichtigt weitere Messwerte zur Bestimmung der Leistungsfähigkeit elektrischer Energiespeicher, wobei ein Messwert die Temperatur des elektrischen Energiespeichers ist und wobei diese Temperatur entweder von dem SOC zur Verfügung gestellt wird **(****Fig. 8** **S5),** oder in alternativen Ausführungsformen anhand von Witterungswerten, wie der Temperatur, den Temperaturschwankungen und der Luftfeuchte der Fahrzeugumgebung **(****Fig. 8** **S1),** der Oberflächentemperatur des Energiespeichers **(****Fig. 8** **S2),** des Fahrzeugs **(****Fig. 8** **S3)** oder des Fahrzeugbodens **(****Fig. 8** **S4),** geschätzt wird. Dabei werden diese Parameter über einen Zeitraum aufgezeichnet und daraus die Temperatur des elektrischen Energiespeichers ermittelt, wobei dieser Zeitraum die Fahrzeit als auch die Stillstandzeit des Fahrzeugs umfasst. Diese Messwerte werden über eine Kommunikationsschnittstelle an die Vorrichtung zur Beurteilung der Leistungsfähigkeit übermittelt.

In einem weiteren Ausführungsbeispiel, wird als weiterer Parameter zur Bestimmung der Leistungsfähigkeit das Alter des elektrischen Energiespeichers hinzugezogen. Zusätzlich wird die Laufleistung des Fahrzeugs mit diesem elektrischen Energiespeichers berücksichtigt. Für das Verfahren zur Beurteilung der Leistungsfähigkeit elektrischer Energiespeicher werden Informationen weiterer elektrischer Fahrzeug-Energiespeicher erhoben.

Zur Identifikation des Fahrzeugs und des darin befindlichen Energiespeichers wird mittels Kamera das Nummernschild gelesen **(****Fig. 8** **S6).** Für die Beurteilung der Fahrzeugtemperatur ist die Kamera **(****Fig. 8** **S6)** zusätzlich oder ausschließlich zur Erzeugung von Wärmebildern fähig. Aus dem Wärmebild wird auf die momentane Temperatur des Energiespeichers geschlossen. Zusätzlich wird der Temperaturverlauf im Stillstand des Fahrzeugs vor der Ladeeinrichtung bestimmt.

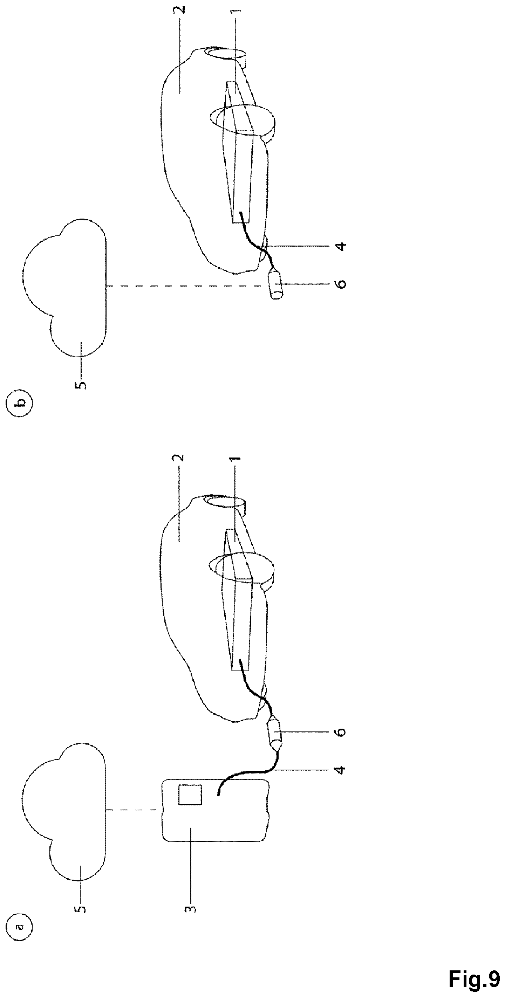

**Fig. 9a** Für den Fall, dass bereits existierende Ladeeinrichtungen **3** nicht die Möglichkeiten zur Implementierung des Verfahrens zur Beurteilung der Leistungsfähigkeit elektrischer Energiespeicher **1** ermöglichen, kann alternativ ein Adapter **6** zur Ergänzung der Ladevorrichtung **3** angebracht werden. Dieser beinhaltet alle Funktionen zur Beurteilung der Leistungsfähigkeit elektrischer Energiespeicher 1 und ist über ein Ladekabel **4** mit der Ladeeinrichtung verbunden. In einer weiteren kommuniziert der Adapter **6** direkt mit dem Cloud-Server **5** über eine Funk-Internetverbindung **(****Fig. 9b****).**

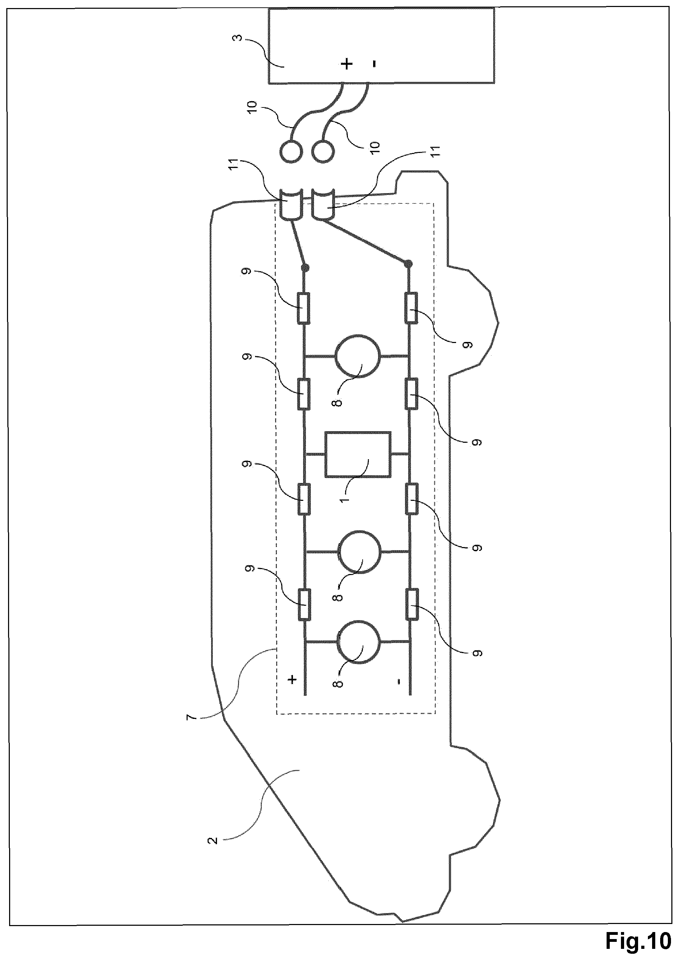

Eine typische Ausführungsform eines Zwischenkreises (7) eines elektrisch-betriebenen Fahrzeugs ist in **Fig. 10** dargestellt. Ein Zwischenkreis (7) hier definiert als die Menge aus galvanisch miteinander gekoppelten Komponenten (1, 8, 9), beispielsweise Nebenverbrauchern, Leistungselektronik, Motoren, Heiz-/Kühleinrichtungen, mit ihren eigenen jeweiligen elektrischen parasitären Eigenschaften, eine dieser Komponenten entsprechend der Fahrzeug-Energiespeicher (1), sowie die dazwischenliegenden parasitären Impedanzen (9), wie beispielweise Übergangs- und Kabel-/Leitungswiderstände, parasitäre Kapazitäten und Induktivitäten und Streukapazitäten und Streuinduktivitäten, und die Anschlüsse der Leistungskanäle (10) für die elektrische Leistungsaufnahme aus der Ladeeinrichtung. In der gezeigten Ausführungsform entspricht die Spannung, die eine Messeinrichtung in der Ladeeinrichtung zwischen den beiden Leistungskanälen (10) misst, der Spannung zwischen den Polen des Zwischenkreises (11), unter Berücksichtigung von Strom bzw. parasitären Effekten.

Der Strom, der hier aus der Ladeeinrichtung in Richtung des Zwischenkreises fließen kann, wird sich entsprechend der parasitären Impedanz-Eigenschaften der Komponenten auf die verschiedenen Komponenten aufteilen. Ein Teil des Stromes wird in den Fahrzeug-Energiespeicher (1) fließen.

Durch geeignete Einstellung und/oder Bestimmung der Spannung durch die Ladestation (3), die sich im Zusammenhang mit dem Stromfluss, welcher ebenfalls bestimmt und/oder eingestellt wird, einstellt, sowie vorbestimmten Zusammenhängen zur Natur der parasitären Eigenschaften, bspw. durch gespeicherte Informationen in einer Cloud, kann der Effekt der parasitären Komponenten bestimmt oder geschätzt und so auf die elektrischen Eigenschaften des Fahrzeug-Energiespeichers geschlossen werden.

### Bezugszeichenliste

- 1: elektrischer Energiespeicher
- 2: elektrisch betriebenes Fahrzeug (EV)
- 3: Ladeeinrichtung
- 4: Ladekabel
- 5: Cloud-Server
- 6: Adapter
- S1: Fahrzeugumgebung
- S2: Oberflächentemperatur des Energiespeichers
- S3: Oberflächentemperatur des Fahrzeugs
- S4: Oberflächentemperatur des Fahrzeugbodens
- S5: State of charge (SOC)
- S6: Kamera
- 7: Zwischenkreis
- 8: sonstige Zwischenkomponenten
- 9: Parasitäre Impedanzen
- 10: Leistungskanäle
- 11: Pol des Zwischenkreises

## Patentansprüche

1. Verfahren zur Bestimmung der Leistungsfähigkeit von elektrischen Energiespeichern (1), umfassend
a) Bereitstellen eines Energiespeichers (1) an einem Zwischenkreis (7),
b) Bereitstellen einer vom Energiespeicher (1) oder dem Zwischenkreis (7) lösbaren Ladeeinrichtung (3),
c) Bereitstellen von mindestens zwei stromführenden Leistungskanälen (10) vorzugsweise direkt von der Ladeeinrichtung (3) zu dem Energiespeicher (1) oder dem Zwischenkreis (7), oder auch über aktive Leistungselektronik, wie beispielsweise einen Wechselrichter, gekoppelt
d) Ermitteln mindestens eines Stroms, insbesondere mindestens einer Stromstärke, an mindestens einem Leistungskanal (10), dem Zwischenkreis (7) oder dem Energiespeicher (1)
e) Ermitteln mindestens einer Spannung oder eines SoC-Ladungszustandes des Energiespeichers (1)
**dadurch gekennzeichnet, dass**
der zeitliche Verlauf des Stroms zur Bestimmung der Leistungsfähigkeit, insbesondere des Widerstandes oder der Kapazität, des Energiespeichers (1) herangezogen wird,
wobei die Bestimmung von Strom vorzugsweise innerhalb der Ladeeinrichtung (3) erfolgt,
wobei zur Bestimmung der Leistungsfähigkeit des Energiespeichers (1) Einflüsse anderer Komponenten (8, 9), insbesondere parasitäre Effekte, als des Energiespeichers (1) am Zwischenkreis (7) und/oder Komponenten zwischen der Ladeeinrichtung (3) und dem Energiespeicher (1) herausgerechnet werden.

2. Verfahren nach Anspruch 1, wobei zur Herausrechnung jener Einflüsse mindestens eine externe physikalische Größe, und/oder bereits bekannte Informationen über den Energiespeicher (1) oder bereits bekannte Informationen über mit dem Energiespeicher (1) vergleichbare Energiespeicher hinzugezogen werden.

3. Verfahren nach Anspruch 1 oder 2, wobei die Bestimmung der Leistungsfähigkeit über eine Approximation vor Ort und/oder eine genauere Berechnung in einer Cloud (5) erfolgt, wobei die Bestimmung der Leistungsfähigkeit, vollständig oder teilweise, insbesondere verteilt, durchgeführt wird
in der Ladeeinrichtung (3), insbesondere deren Recheneinheiten,
in mindestens einer Recheneinheit in unmittelbarer Nähe der Ladeeinrichtung (3), insbesondere in einem Umkreis von 100 m, insbesondere 50 m, insbesondere 30 m,
und/oder
auf einem oder mehreren, insbesondere verteilten, Servern (5), insbesondere im Rahmen von Cloud- und/oder Edge-Computing.

4. Verfahren nach einem der vorhergehenden Ansprüche, wobei die Leistungsfähigkeit in einem Zusammenhang mit der Veränderung von Widerstand, und/oder Ladungsaufnahmefähigkeit im Vergleich zueinander und/oder im Vergleich zu einer Bestimmung der Werte zu einem vorangegangenen Zeitpunkt steht und/oder wobei die Leistungsfähigkeit dadurch bestimmt wird, dass zumindest der Widerstand und/oder die Ladungsaufnahmefähigkeit bestimmt und mit dem Widerstand und/oder die Ladungsaufnahmefähigkeit bekannter, mit dem Energiespeicher vergleichbarer, Energiespeicher verglichen wird und/oder
wobei der Ladezustand des Energiespeichers zur Bestimmung der Leistungsfähigkeit hinzugezogen wird, insbesondere wobei der Ladezustand über eine zusätzliche Kommunikationsschnittstelle zwischen Energiespeicher und/oder einem Fahrzeug einerseits und Ladeeinrichtung andererseits übermittelt wird.

5. Verfahren nach Anspruch **4,** wobei über eine zusätzliche Kommunikationsschnittstelle zwischen Energiespeicher und/oder einem Fahrzeug einerseits und Ladeeinrichtung andererseits ferner übermittelt werden eines oder mehrere aus:
- Spannung des Energiespeichers (1) und/oder des Zwischenkreises (7)
- Spannungen einzelner Teile des Energiespeichers (1), insbesondere einzelner Zellen und/oder Module und/oder Stränge der Batterie
- Stromstärken einzelner Teile des Energiespeichers (1), insbesondere einzelner Zellen und/oder Module und/oder Stränge der Batterie
- Temperaturen, insbesondere durchschnittliche, minimale, maximale oder andere Aggregationen von Temperaturen des Batteriesystems (1)
- Alterungskenngrößen des Energiespeichers (1), insbesondere Kapazitäten, Widerstände, Impedanzen, Alter, Laufleistung, State of Health (SOH),
- und/oder Nominalgrößen des Energiespeichers (1), insbesondere nominale Nennkapazität des Energiespeichers im Neuzustand.

6. Verfahren nach einem der Ansprüche 4 oder 5, wobei der Ladezustand aus der an dem Energiespeicher (1) anliegenden Spannung ermittelt wird oder anhand hinterlegter Daten geschätzt wird und/oder wobei der Ladezustand bestimmt und/oder geschätzt wird durch Nutzung einer zeitlichen Integration eines Stromsignals und/oder eines Leistungssignals und/oder wobei der Ladezustand bestimmt und/oder geschätzt wird unter Nutzung von Effekten von Ruhephasen und/oder Quasi-Ruhephasen, insbesondere relaxierte Spannungen und/oder Phasen der noch fortschreitenden Relaxation der Spannung und/oder wobei der Ladezustand bestimmt und/oder geschätzt wird durch Nutzung einer zeitlichen Integration eines Stromsignals und/oder eines Leistungssignals,
zeitlich vor und/oder nach
den Ruhephasen und/oder Quasi-Ruhephasen zur Verbesserung der Bestimmung der Leistungsfähigkeit.

7. Verfahren nach einem der vorhergehenden Ansprüche, wobei ein oder mehrere Messwerte verwendet werden, um die Leistungsfähigkeit über einen Zeitraum abzuschätzen und/oder zu berechnen; und/oder wobei eine künstliche Intelligenz anhand von Messwerten und/oder hinterlegten Daten eine Einstellung der Ladestromstärke und/oder Spannung und/oder Ladezeit vornimmt.

8. Verfahren nach Anspruch 7, wobei ein Messwert eine repräsentative Temperatur des Energiespeichers und/oder eines Fahrzeugs umfasst, insbesondere wobei die repräsentative Temperatur die Umgebungstemperatur und/oder Oberflächentemperatur und/oder durchschnittliche Temperatur und/oder minimale Temperatur und/oder maximale Temperatur umfasst und/oder wobei der Messwert die Oberflächentemperatur des Energiespeichers und/oder eines Fahrzeugbodens umfasst.

9. Verfahren nach einem der Ansprüche 7 oder 8, wobei die Messwerte über eine zusätzliche Kommunikationsschnittstelle zwischen Energiespeicher und/oder einem Fahrzeug einerseits und Ladeeinrichtung andererseits an letztere übermittelt werden und/oder wobei beim Herausrechnen von Einflüssen anderer Komponenten, insbesondere parasitärer Effekte, mindestens einer oder mehrere der Messwerte genutzt werden und/oder wobei das Herausrechnen parasitärer Einflüsse auf der Auswertung von Relaxationsvorgängen und/oder Relaxationsphasen in einem Spannungssignal des Energiespeichers und/oder des Zwischenkreises beruht, insbesondere zu einem Identifizieren, einem Bestimmen und/oder einem Abschätzen von Impedanzeigenschaften und/oder -kenngrößen des Energiespeichers.

10. Verfahren nach einem der Ansprüche 7 - 9, wobei ein Messwert das Alter des Energiespeichers, die Laufzeit und/oder die Laufleistung eines Fahrzeugs umfasst und/oder eines oder mehrere umfasst aus:
- Spannung des Energiespeichers (1) und/oder des Zwischenkreises (7)
- Spannungen einzelner Teile des Energiespeichers (1), insbesondere einzelner Zellen und/oder Module und/oder Stränge der Batterie
- Stromstärken einzelner Teile des Energiespeichers (1), insbesondere einzelner Zellen und/oder Module und/oder Stränge der Batterie
- Temperaturen, insbesondere durchschnittliche, minimale, maximale oder andere Aggregationen von Temperaturen des Batteriesystems
- Alterungskenngrößen des Energiespeichers (1), insbesondere Kapazitäten, Widerstände, Impedanzen, Alter, Laufleistung, State of Health (SOH),
- und/oder Nominalgrößen des Energiespeichers (1), insbesondere nominale Nennkapazität des Energiespeichers im Neuzustand.

11. Verfahren nach einem der vorhergehenden Ansprüche, wobei die Ladestromstärke in Abhängigkeit mindestens eines Messwertes angepasst wird und/oder wobei ein oder mehrere Fahrzeuge und/oder, insbesondere in dem oder den Fahrzeugen enthaltene, Energiespeicher mit einem Identifikationsverfahren eindeutig identifiziert werden und/oder welches ausgeführt werden kann und/oder eine Kommunikation zwischen einer Ladeeinrichtung (3) und einem Energiespeicher (1) ermöglichen kann, wenn diese nicht aufeinander abgestimmt sind.

12. Vorrichtung, insbesondere kommunikativer Adapter (6) zur beidseitigen Anordnung an und/oder Verbindung eines Energiespeichers (1) und einer Ladeeinrichtung (3), zur Kommunikation mit mindestens einem Energiespeicher (1) und/oder an einem Energiespeicher (1) angeordneten Zwischenkreis (7), insbesondere ferner eingerichtet zur Kommunikation mit einer Ladeeinrichtung (3) für den Energiespeicher (1), insbesondere ferner eingerichtet zur Kommunikation mit einem oder mehreren Servern und/oder Recheneinheiten, insbesondere unter Kommunikation mit einer Computing-Cloud (5), welche Vorrichtung dazu eingerichtet ist, einem Nutzer die Bestimmung einer Leistungsfähigkeit nach einem Verfahren nach einem der Ansprüche 1 bis 11 effektiv bereitzustellen, insbesondere zur Kenntnisnahme und/oder weiteren Datenverarbeitung effektiv verfügbar zu machen,
insbesondere wenn die Ladeeinrichtung (3) und der Energiespeicher (1) nicht aufeinander abgestimmt sind.

13. Computer, Computernetzwerk oder Computersystem, insbesondere verteiltes Computersystem, welches dazu eingerichtet ist, um ein Verfahren unter Verwendung der Vorrichtung nach Anspruch 12 zur Bestimmung der Leistungsfähigkeit von elektrischen Energiespeichern (1) nach einem der Ansprüche 1 bis 11 auszuführen.

14. Computerprogramm oder computerlesbares Medium, umfassend computerausführbare Anweisungen, welche, unter Verwendung der Vorrichtung nach Anspruch 12, bei der Ausführung durch einen Computer diesen veranlassen, das Verfahren zur Bestimmung der Leistungsfähigkeit von elektrischen Energiespeichern (1) nach einem der Ansprüche 1 bis 11 zu bewirken.

15. Verfahren nach einem der Ansprüche 1 bis 11 unter Verwendung der Vorrichtung nach Anspruch 12 oder 13, um eine Kommunikation zwischen einer Ladeeinrichtung (3) und einem Energiespeicher (1) zu ermöglichen, wenn diese nicht aufeinander abgestimmt sind.

## Claims

1. A method for determining the performance of electrical energy storage devices (1), comprising
a) providing an energy storage device (1) at a DC link (7),
b) providing a charging device (3) that can be disconnected from the energy storage device (1) or the intermediate circuit (7),
c) providing at least two current-carrying power channels (10), preferably directly from the charging device (3) to the energy storage device (1) or the DC link (7), or coupled via active power electronics, such as an inverter,
d) Determining at least one current, in particular at least one current magnitude, at at least one power channel (10), the intermediate circuit (7), or the energy storage device (1)
e) Determining at least one voltage or a SoC state of charge of the energy storage device (1)
wherein the temporal profile of the current is used to determine the performance characteristics, in particular the resistance or capacitance, of the energy storage device (1),
wherein the determination of current is preferably performed within the charging device (3),
wherein, to determine the performance characteristics of the energy storage device (1), the effects of other components (8, 9)-in particular parasitic effects-other than the energy storage device (1) on the DC link (7) and/or components between the charging device (3) and the energy storage device (1) are factored out.

2. A method according to claim 1, wherein, to account for those influences, at least one external physical quantity and/or already known information about the energy storage device (1) or already known information about energy storage devices comparable to the energy storage device (1) is taken into account.

3. A method according to claim 1 or 2, wherein the determination of performance is carried out via an on-site approximation and/or a more precise calculation in a cloud (5), wherein the determination of performance is carried out, in whole or in part, in particular in a distributed manner,
in the charging device (3), in particular its computing units,
in at least one computing unit in the immediate vicinity of the charging device (3), in particular within a radius of 100 m, in particular 50 m, in particular 30 m,
and/or
on one or more, in particular distributed, servers (5), in particular within the framework of cloud and/or edge computing.

4. A method according to any of the preceding claims, wherein the performance is related to the change in resistance, and/or charge acceptance capacity relative to one another and/or relative to a determination of the values at a previous point in time, and/or wherein the performance is determined by measuring at least the resistance and/or the charge acceptance capacity and comparing them with the resistance and/or the charge acceptance capacity of known energy storage devices comparable to the energy storage device, and/or
wherein the state of charge of the energy storage device is taken into account to determine the performance, in particular wherein the state of charge is transmitted via an additional communication interface between the energy storage device and/or a vehicle on the one hand and a charging device on the other hand.

5. The method according to claim 4, wherein the following are further transmitted via an additional communication interface between the energy storage device and/or a vehicle on the one hand and the charging device on the other hand: one or more of the following:
- the voltage of the energy storage device (1) and/or the DC link (7)
- voltages of individual components of the energy storage device (1), in particular individual cells and/or modules and/or battery strings
- current values of individual parts of the energy storage device (1), in particular individual cells and/or modules and/or strings of the battery
- Temperatures, in particular average, minimum, maximum, or other aggregates of temperatures of the battery system (1)
- Aging parameters of the energy storage system (1), in particular capacities, resistances, impedances, age, cycle life, SoH State of Health,
- and/or nominal parameters of the energy storage system (1), in particular the nominal capacity of the energy storage system when new.

6. A method according to any one of claims 4 or 5, wherein the state of charge is determined from the voltage applied to the energy storage device (1) or is estimated based on stored data, and/or wherein the state of charge is determined and/or estimated by using a time integration of a current signal and/or a power signal, and/or wherein the state of charge is determined and/or estimated by utilizing effects of rest phases and/or quasi-rest phases, in particular relaxed voltages and/or phases of ongoing voltage relaxation, and/or wherein the state of charge is determined and/or estimated by using a time integration of a current signal and/or a power signal,
occurring before and/or after
the rest phases and/or quasi-rest phases to improve the determination of performance.

7. A method according to any one of the preceding claims, wherein one or more measured values are used to estimate and/or calculate performance over a period of time; and/or wherein an artificial intelligence system adjusts the charging current and/or voltage and/or charging time based on measured values and/or stored data.

8. A method according to claim 7, wherein a measured value comprises a representative temperature of the energy storage device and/or a vehicle, in particular wherein the representative temperature comprises the ambient temperature and/or surface temperature and/or average temperature and/or minimum temperature and/or maximum temperature, and/or wherein the measured value comprises the surface temperature of the energy storage device and/or a vehicle floor.

9. A method according to any one of claims 7 or 8, wherein the measured values are transmitted to the charging device via an additional communication interface between the energy storage device and/or a vehicle on the one hand and the charging device on the other hand, and/or wherein, when compensating for the influence of other components, in particular parasitic effects, at least one or more of the measured values are used, and/or wherein the elimination of parasitic influences is based on the evaluation of relaxation processes and/or relaxation phases in a voltage signal of the energy storage device and/or the DC link, in particular for identifying, determining, and/or estimating impedance characteristics and/or parameters of the energy storage device.

10. A method according to any one of claims 7-9, wherein a measured value comprises the age of the energy storage device, the operating time, and/or the mileage of a vehicle and/or comprises one or more of the following:
- the voltage of the energy storage device (1) and/or the DC link (7)
- voltages of individual components of the energy storage device (1), in particular individual cells and/or modules and/or battery strings
- current values of individual parts of the energy storage device (1), in particular individual cells and/or modules and/or battery strings
- Temperatures, in particular average, minimum, maximum, or other aggregates of temperatures of the battery system
- Aging parameters of the energy storage system (1), in particular capacities, resistances, impedances, age, cycle life, SoH State of Health,
- and/or nominal parameters of the energy storage system (1), in particular the nominal capacity of the energy storage system when new.

11. A method according to any of the preceding claims, wherein the charging current is adjusted as a function of at least one measured value, and/or wherein one or more vehicles and/or energy storage devices-in particular those contained in the vehicle(s)-are uniquely identified using an identification method, and/or which can be executed, and/or communication between a charging device (3) and an energy storage device (1) when they are not synchronized with each other.

12. Device, in particular a communication adapter (6), for bilateral attachment to and/or connection of an energy storage device (1) and a charging device (3), for communication with at least one energy storage device (1) and/or an intermediate circuit (7) arranged on an energy storage device (1), further configured, in particular, to communicate with a charging device (3) for the energy storage device (1), further configured, in particular, to communicate with one or more servers and/or computing units, in particular via communication with a computing cloud (5), which device is configured to effectively provide a user with the determination of a performance capability according to a method as described in any of claims 1 through 11, in particular to make it effectively available for review and/or further data processing,
in particular when the charging device (3) and the energy storage device (1) are not matched to one another.

13. A computer, computer network, or computer system, in particular a distributed computer system, configured to execute a method using the device according to claim 12 for determining the performance of electrical energy storage devices (1) in accordance with any of claims 1 through 11.

14. A computer program or computer-readable medium comprising computer-executable instructions which, when executed by a computer using the device according to claim 12, cause the computer to perform the method for determining the performance of electrical energy storage devices (1) according to any one of claims 1 through 11.

15. A method according to any one of claims 1 through 11, using the device according to claim 12 or 13 to enable communication between a charging device (3) and an energy storage device (1) when they are not matched to each other.

## Revendications

1. Procédé de détermination des performances de dispositifs de stockage d'énergie électrique (1), comprenant
a) la mise à disposition d'un accumulateur d'énergie (1) sur un circuit intermédiaire (7),
b) la mise en place d'un dispositif de charge (3) pouvant être déconnecté du dispositif de stockage d'énergie (1) ou du circuit intermédiaire (7),
c) la mise en place d'au moins deux canaux de puissance conducteurs de courant (10), de préférence couplés directement du dispositif de charge (3) au dispositif de stockage d'énergie (1) ou au circuit intermédiaire (7), ou encore via une électronique de puissance active, telle qu'un onduleur,
d) Détermination d'au moins un courant, en particulier d'au moins une intensité de courant, sur au moins un canal de puissance (10), le circuit intermédiaire (7) ou le dispositif de stockage d'énergie (1)
e) Détermination d'au moins une tension ou d'un état de charge SoC du dispositif de stockage d'énergie (1)
l'évolution temporelle du courant étant utilisée pour déterminer les caractéristiques de performance, notamment la résistance ou la capacité, du dispositif de stockage d'énergie (1),
la détermination du courant s'effectuant de préférence au sein du dispositif de charge (3),
dans lequel, pour déterminer les performances du dispositif de stockage d'énergie (1), on élimine les influences d'autres composants (8, 9) - en particulier les effets parasites - autres que le dispositif de stockage d'énergie (1) au niveau du circuit intermédiaire (7) et/ou des composants situés entre le dispositif de charge (3) et le dispositif de stockage d'énergie (1).

2. Procédé selon la revendication 1, dans lequel, pour éliminer ces influences, on utilise au moins une grandeur physique externe et/ou des informations déjà connues sur le dispositif de stockage d'énergie (1) ou des informations déjà connues sur des dispositifs de stockage d'énergie comparables au dispositif de stockage d'énergie (1).

3. Procédé selon la revendication 1 ou 2, dans lequel la détermination de la capacité de puissance s'effectue par une approximation sur site et/ou un calcul plus précis dans un cloud (5), la détermination de la capacité de puissance étant effectuée, en tout ou en partie, notamment de manière distribuée,
dans le dispositif de recharge (3), en particulier dans ses unités de calcul,
dans au moins une unité de calcul située à proximité immédiate du dispositif de charge (3), notamment dans un rayon de 100 m, notamment de 50 m, notamment de 30 m,
et/ou
sur un ou plusieurs serveurs (5), notamment distribués, en particulier dans le cadre du cloud computing et/ou de l'edge computing.

4. Procédé selon l'une des revendications précédentes, dans lequel la performance est mise en relation avec la variation de la résistance, et/ou de la capacité de stockage de charge, soit entre elles, soit par rapport à une détermination des valeurs à un moment antérieur, et/ou dans lequel les performances sont déterminées en mesurant au moins la résistance et/ou la capacité de stockage de charge et en les comparant à la résistance et/ou à la capacité de stockage de charge de dispositifs de stockage d'énergie connus, comparables au dispositif de stockage d'énergie en question, et/ou l'état de charge du dispositif de stockage d'énergie étant pris en compte pour déterminer la performance, en particulier l'état de charge étant transmis via une interface de communication supplémentaire entre le dispositif de stockage d'énergie et/ou un véhicule d'une part, et un dispositif de charge d'autre part.

5. Procédé selon la revendication 4, dans lequel sont en outre transmises, via une interface de communication supplémentaire entre le dispositif de stockage d'énergie et/ou un véhicule d'une part et le dispositif de charge d'autre part, un ou plusieurs des éléments suivants :
- la tension du dispositif de stockage d'énergie (1) et/ou du circuit intermédiaire (7)
- les tensions de différentes parties du dispositif de stockage d'énergie (1), en particulier des différentes cellules et/ou modules et/ou chaînes de la batterie
- les intensités de courant de différentes parties du dispositif de stockage d'énergie (1), en particulier de cellules individuelles et/ou de modules et/ou de chaînes de la batterie
- des températures, notamment les températures moyennes, minimales, maximales ou d'autres agrégats de températures du système de batterie (1)
- Paramètres de vieillissement du dispositif de stockage d'énergie (1), notamment les capacités, les résistances, les impédances, l'âge, le nombre de cycles, l'état de santé SOH,
- et/ou les valeurs nominales du système de stockage d'énergie (1), en particulier la capacité nominale du système de stockage d'énergie à l'état neuf.

6. Procédé selon l'une des revendications 4 ou 5, dans lequel l'état de charge est déterminé à partir de la tension appliquée au dispositif de stockage d'énergie (1) ou est estimé à partir de données enregistrées et/ou dans lequel l'état de charge est déterminé et/ou estimé en utilisant une intégration dans le temps d'un signal de courant et/ou d'un signal de puissance et/ou dans lequel l'état de charge est déterminé et/ou estimé en utilisant les effets des phases de repos et/ou des phases de quasi-repos, notamment des tensions de relaxation et/ou des phases de relaxation encore en cours de la tension et/ou dans lequel l'état de charge est déterminé et/ou estimé en utilisant une intégration dans le temps d'un signal de courant et/ou d'un signal de puissance,
avant et/ou après
les phases de repos et/ou les quasi-phases de repos afin d'améliorer la détermination des performances.

7. Procédé selon l'une des revendications précédentes, dans lequel une ou plusieurs valeurs mesurées sont utilisées pour estimer et/ou calculer la capacité de performance sur une période donnée ; et/ou dans lequel une intelligence artificielle procède, à partir de valeurs mesurées et/ou de données enregistrées, à un réglage de l'intensité du courant de charge et/ou de la tension et/ou de la durée de charge.

8. Procédé selon la revendication 7, dans lequel une valeur mesurée comprend une température représentative du dispositif de stockage d'énergie et/ou d'un véhicule, en particulier dans lequel la température représentative comprend la température ambiante et/ou la température de surface et/ou la température moyenne et/ou la température minimale et/ou la température maximale, et/ou dans lequel la valeur mesurée comprend la température de surface du dispositif de stockage d'énergie et/ou du plancher d'un véhicule.

9. Procédé selon l'une des revendications 7 ou 8, dans lequel les valeurs mesurées sont transmises à ce dernier via une interface de communication supplémentaire entre le dispositif de stockage d'énergie et/ou un véhicule, d'une part, et le dispositif de charge, d'autre part, et/ou dans lequel, lors de la compensation des influences d'autres composants, en particulier des effets parasites, au moins une ou plusieurs des valeurs mesurées sont utilisées et/ou dans lequel l'élimination des influences parasites repose sur l'analyse des processus de relaxation et/ou des phases de relaxation dans un signal de tension du dispositif de stockage d'énergie et/ou du circuit intermédiaire, notamment en vue d'identifier, de déterminer et/ou d'estimer les propriétés d'impédance et/ou les paramètres d'impédance du dispositif de stockage d'énergie.

10. Procédé selon l'une des revendications 7 à 9, dans lequel une valeur mesurée comprend l'âge du dispositif de stockage d'énergie, la durée de fonctionnement et/ou le kilométrage d'un véhicule et/ou comprend une ou plusieurs des valeurs suivantes :
- la tension du dispositif de stockage d'énergie (1) et/ou du circuit intermédiaire (7)
- les tensions de différentes parties du dispositif de stockage d'énergie (1), en particulier des différentes cellules et/ou modules et/ou chaînes de la batterie
- les intensités de courant de différentes parties du dispositif de stockage d'énergie (1), en particulier de cellules individuelles et/ou de modules et/ou de chaînes de la batterie
- les températures, notamment les températures moyennes, minimales, maximales ou d'autres agrégats de températures du système de batterie
- paramètres de vieillissement du dispositif de stockage d'énergie (1), notamment les capacités, les résistances, les impédances, l'âge, la durée de fonctionnement, l'état de santé SOH,
- et/ou les valeurs nominales du système de stockage d'énergie (1), en particulier la capacité nominale du système de stockage d'énergie à l'état neuf.

11. Procédé selon l'une des revendications précédentes, dans lequel l'intensité du courant de charge est ajustée en fonction d'au moins une valeur mesurée et/ou dans lequel un ou plusieurs véhicules et/ou des accumulateurs d'énergie, notamment ceux contenus dans le ou les véhicules, sont identifiés de manière univoque à l'aide d'un procédé d'identification et/ou dans lequ , qui peut être exécuté, et/ou une communication entre d'un dispositif de charge (3) et un accumulateur d'énergie (1) lorsque ceux-ci ne sont pas synchronisés.

12. Dispositif, en particulier adaptateur de communication (6) destiné à être disposé de part et d'autre et/ou à relier un accumulateur d'énergie (1) et un dispositif de charge (3), pour communiquer avec au moins un accumulateur d'énergie (1) et/ou un circuit intermédiaire (7) disposé sur un accumulateur d'énergie (1), en particulier également conçu pour communiquer avec un dispositif de charge (3) destiné au dispositif de stockage d'énergie (1), en outre spécialement conçu pour communiquer avec un ou plusieurs serveurs et/ou unités de calcul, notamment en communication avec un cloud informatique (5), lequel dispositif est conçu pour permettre effectivement à un utilisateur de déterminer une performance selon un procédé correspondant à l'une des revendications 1 à 11, notamment pour la mettre effectivement à disposition à des fins de consultation et/ou de traitement ultérieur des données,
en particulier lorsque le dispositif de charge (3) et le dispositif de stockage d'énergie (1) ne sont pas adaptés l'un à l'autre.

13. Ordinateur, réseau informatique ou système informatique, en particulier système informatique distribué, qui est conçu pour exécuter un procédé utilisant le dispositif selon la revendication 12 afin de déterminer la capacité de stockage d'énergie électrique (1) selon l'une des revendications 1 à 11.

14. Programme informatique ou support lisible par ordinateur, comprenant des instructions exécutables par ordinateur qui, à l'aide du dispositif selon la revendication 12, lorsqu'elles sont exécutées par un ordinateur, amènent celui-ci à mettre en œuvre le procédé de détermination des performances de dispositifs de stockage d'énergie électrique (1) selon l'une des revendications 1 à 11.

15. Procédé selon l'une des revendications 1 à 11, utilisant le dispositif selon la revendication 12 ou 13, pour permettre une communication entre un dispositif de charge (3) et un dispositif de stockage d'énergie (1) lorsque ceux-ci ne sont pas adaptés l'un à l'autre.
